# FASCICULE DE BREVET EUROPEEN

(11) **EP 4 379 800 B1**
(45) Date de publication et mention de la délivrance du brevet: **02.04.2025**
(21) Numéro de dépôt: 23212871.0
(22) Date de dépôt: 29.11.2023
(51) Int. Cl.: H10H 20/80, H10H 20/813, H10H 20/815, H10H 20/82, H10H 29/30

(54) **PROCEDE DE FABRICATION PAR POROSIFICATION ELECTROCHIMIQUE DIFFERENCIEE D'UN SUBSTRAT DE CROISSANCE COMPORTANT DES MESAS PRESENTANT DIFFERENTS NIVEAUX DE POROSIFICATION**
VERFAHREN ZUR HERSTELLUNG EINES WACHSTUMSSUBSTRATS MIT UNTERSCHIEDLICHEN ELEKTROCHEMISCHE POROSIFIKATIONSEBENEN MIT MESAS MIT UNTERSCHIEDLICHEN PORENBILDUNGSGRADEN
METHOD FOR MANUFACTURING BY DIFFERENT ELECTROCHEMICAL POROSIFICATION A GROWTH SUBSTRATE COMPRISING MESAS HAVING DIFFERENT POROSIFICATION LEVELS

(30) Priorité: 02.12.2022 FR 2212704
(43) Date de publication de la demande: 05.06.2024
(73) Titulaire: Commissariat à l'Energie Atomique et aux Energies Alternatives, 75015 Paris (FR)
(72) Inventeur: ROL, FABIAN, 38054 Grenoble cedex 09 (FR); DUSSAIGNE, Emilie, 38054 Grenoble cedex 09 (FR); PERNEL, Carole, 38054 Grenoble cedex 09 (FR); DUPRE, Ludovic, 38054 Grenoble cedex 09 (FR)
(74) Mandataire: Brevalex

(56) Documents cités:
- DE-A1- 102020 128 679
- US-A1- 2022 285 584

## Description

### DOMAINE TECHNIQUE

Le domaine de l'invention est celui des procédés de fabrication d'un substrat de croissance comportant des mésas permettant la réalisation d'une matrice de diodes adaptées à émettre ou à détecter, de manière native, un rayonnement lumineux à différentes longueurs d'onde.

### ÉTAT DE LA TECHNIQUE ANTÉRIEURE

Il existe des procédés de fabrication d'une matrice de diodes électroluminescentes adaptée à émettre, de manière native, un rayonnement lumineux à différentes longueurs d'onde. La matrice de diodes peut alors comporter des diodes adaptées à émettre une lumière rouge, d'autres diodes une lumière verte, et d'autres enfin une lumière bleue. Une telle matrice de diodes forme alors un micro-écran à émission native RGB (pour *Red, Green, Blue,* en anglais).

Les diodes sont dites à émission native, dans le sens où la zone active de chaque diode émettant à une longueur d'onde donnée diffère des zones actives des diodes émettant à une autre longueur d'onde. Dans le cas des diodes réalisées à base d'InGaN, les zones actives diffèrent les unes des autres par la proportion d'indium dans les puits quantiques.

Une telle matrice de diodes à émission native se distingue ainsi des technologies à conversion de couleurs où les diodes émettent toutes à une même longueur d'onde, par exemple dans le bleu, et sont revêtues chacune d'un plot comportant des luminophores, par exemple des nanocristaux semiconducteurs formant des boîtes quantiques, pour convertir au moins en partie la lumière incidente en une lumière d'une autre longueur d'onde.

Pour fabriquer une matrice de diodes à émission native, une approche consiste à utiliser un substrat de croissance présentant des mésas ayant été en partie rendues poreuses lors d'une étape de porosification électrochimique. Cette technique de porosification électrochimique est présentée notamment dans l'article de Griffin et Oliver intitulé Porous nitride semiconductors reviewed, J. Phys. D: Appl. Phys. 53 (2020) 383002.

Le document EP3840065A1 décrit un exemple de procédé de fabrication d'un substrat de croissance puis d'une matrice de diodes utilisant la technique de porosification électrochimique. Le procédé comporte la réalisation d'un substrat de croissance (également appelé pseudo-substrat) présentant plusieurs mésas en InGaN, formées chacune d'une portion dopée en InGaN rendu poreux lors d'une étape de porosification électrochimique, et d'une portion de reprise d'épitaxie en InGaN non intentionnellement dopé ou faiblement dopé de sorte qu'il n'est pas porosifié (il reste intègre ou dense, donc non poreux). Les diodes sont ensuite réalisées par épitaxie à partir des portions de reprise d'épitaxie.

Le document DE 10 2020 128679 A1 divulgue un procédé de fabrication d'un substrat avec un domaine poreux.

Les portions dopées des mésas peuvent présenter des niveaux de dopage différents d'une mésa à l'autre, de sorte que les mésas présentent des niveaux de porosification différents et donc des taux de relaxation différents. Les diodes réalisées à partir des différentes mésas comportent alors des puits quantiques ayant une proportion d'indium plus ou moins importante, permettant ainsi d'obtenir des pixels émissifs à différentes longueurs d'onde.

Cependant, pour obtenir des mésas dont les couches dopées en InGaN présentent différents niveaux de dopage d'une mésa à l'autre, il est nécessaire d'effectuer, avant l'étape de réalisation des mésas, une étape d'implantation spatialement localisée de dopants dans une couche d'InGaN pleine plaque, ce qui complexifie le procédé de fabrication.

### EXPOSÉ DE L'INVENTION

L'invention a pour objectif de remédier au moins en partie aux inconvénients de l'art antérieur, et plus particulièrement de proposer un procédé de fabrication d'un substrat de croissance, adapté à la réalisation d'une matrice de diodes à base d'InGaN, comportant des mésas ayant différents niveaux de porosification, sans qu'il ait été nécessaire de réaliser des implantations spatialement localisées de dopants.

Pour cela, l'objet de l'invention est un procédé de fabrication d'un substrat de croissance adapté à la réalisation par épitaxie d'une matrice de diodes à base d'InGaN, comportant les étapes suivantes :
o fournir un empilement cristallin à base de GaN, comportant : une couche inférieure dopée ; et une couche supérieure réalisée à base d'Inₓ₂Ga₁₋ₓ₂N avec x2>0, reposant sur et au contact de la couche inférieure dopée ; où :
   - la couche inférieure dopée présente une proportion d'indium x1≥0 prédéfinie de sorte qu'elle est non absorbante d'un rayonnement lumineux d'illumination ayant une longueur d'onde centrale prédéfinie, et la couche supérieure présente une proportion d'indium x2>0 prédéfinie de sorte qu'elle est absorbante du rayonnement lumineux d'illumination ;
   - la couche inférieure dopée présente un niveau de dopage prédéfini de sorte qu'elle est porosifiable à une tension électrique de valeur V_{ECE} prédéfinie, et la couche supérieure présente un niveau de dopage prédéfini de sorte qu'elle est non porosifiable à la tension électrique V_{ECE} prédéfinie ;
o réalisation de mésas M₍ᵢ₎, avec i allant de 0 à 2, par gravure localisée de la couche supérieure pour former des portions supérieures de mésas et d'au moins une partie de la couche inférieure dopée pour former des portions inférieures de mésas ; puis
o dépôt d'une couche d'encapsulation en un matériau électriquement isolant, recouvrant au moins une mésa notée M₍₀₎, de sorte que ladite mésa M₍₀₎ n'est pas porosifiée lors d'une porosification électrochimique de mésas notées M₍₁₎ et M₍₂₎; puis
o porosification électrochimique des portions inférieure et supérieure d'au moins une mésa M₍₂₎ par : porosification photo-assistée de la portion supérieure de la mésa M₍₂₎ par émission du rayonnement lumineux d'illumination ; et porosification non photo-assistée de la portion inférieure de la mésa M₍₂₎ par application de la tension électrique de valeur V_{ECE};
o porosification électrochimique de l'une seulement des portions inférieure et supérieure d'au moins une mésa M₍₁₎ par : porosification photo-assistée de la portion supérieure de la mésa M₍₁₎ au cours de celle de la portion supérieure de la mésa M₍₂₎ ; ou porosification non photo-assistée de la portion inférieure de la mésa M₍₁₎ au cours de celle de la portion inférieure de la mésa M₍₂₎;
o retrait au moins en partie de la couche d'encapsulation, de manière à rendre libre une surface supérieure de la mésa M₍₀₎.

Certains aspects préférés mais non limitatifs de ce procédé de fabrication sont les suivants.

La porosification photo-assistée et la porosification non photo-assistée peuvent être effectuées lors d'étapes distinctes.

Le procédé peut comporter les étapes distinctes suivantes : une étape de porosification photo-assistée des portions supérieures des mésas M₍₁₎ et M₍₂₎, les mésas M₍₁₎ et M₍₂₎ étant au contact d'un électrolyte liquide ; et une étape de porosification non photo-assistée de la portion inférieure des mésas M₍₂₎, les mésas M₍₁₎ étant recouvertes d'une couche d'encapsulation réalisée en un matériau électriquement isolant, seules les mésas M₍₂₎ étant au contact d'un électrolyte liquide.

En variante, le procédé peut comporter les étapes distinctes suivantes : une étape de porosification photo-assistée de la portion supérieure des mésas M₍₂₎, les mésas M₍₁₎ étant recouvertes d'une couche d'encapsulation réalisée en un matériau électriquement isolant, seules les mésas M₍₂₎ étant au contact d'un électrolyte liquide ; une étape de porosification non photo-assistée de la portion inférieure des mésas M₍₁₎ et M₍₂₎, les mésas M₍₁₎ et M₍₂₎ étant au contact d'un électrolyte liquide.

En variante, la porosification photo-assistée et la porosification non photo-assistée peuvent être effectuées lors d'une même étape, une couche opaque d'encapsulation, réalisée en un matériau opaque au rayonnement lumineux d'illumination, recouvrant au moins en partie une surface supérieure des mésas M₍₁₎ tout en laissant libre une surface latérale de la portion inférieure des mésas M₍₁₎.

L'empilement cristallin peut comporter une couche continue de reprise d'épitaxie, reposant sur la couche supérieure, et réalisée à base d'InGaN ayant une proportion d'indium x3>0 prédéfinie de sorte qu'elle est non absorbante du rayonnement lumineux d'illumination, et présentant un niveau de dopage prédéfini de sorte qu'elle est non porosifiable à la tension électrique V_{ECE} prédéfinie.

L'empilement cristallin peut ne pas comporter pas de couche continue de reprise d'épitaxie, de sorte que la couche supérieure présente une face supérieure libre, des portions de reprise d'épitaxie réalisée à base d'InGaN étant réalisés à partir d'une surface supérieure des portions supérieures des mésas M₍₁₎ après la porosification des mésas M₍₁₎ et M₍₂₎.

Lors de la porosification photo-assistée, une tension électrique peut être appliquée entre le substrat de croissance et une électrolyte liquide dans lequel il est plongé, d'une valeur V_{PECE} prédéfinie de sorte que les portions inférieures des mésas M₍₁₎ ne sont pas porosifiées.

L'invention concerne également un procédé de fabrication d'un dispositif optoélectronique, comportant les étapes suivantes :
o fabrication du substrat de croissance par le procédé selon l'une quelconque des caractéristiques précédentes ; puis
o fabrication d'une matrice de diodes D₍ᵢ₎ par épitaxie à partir des mésas M₍ᵢ₎ du substrat de croissance, les diodes étant alors adaptées à émettre ou à détecter un rayonnement lumineux à différentes longueurs d'onde, la longueur d'onde étant différente d'une catégorie de mésas M₍ᵢ₎ à l'autre.

L'invention porte également sur un substrat de croissance, adapté à la réalisation par épitaxie d'une matrice de diodes à base d'InGaN, comportant :
o une couche support ;
o des mésas M₍ᵢ₎, avec i allant de 0 à 2, réalisées à base de GaN cristallin, reposant sur la couche support, et comportant chacune : une portion inférieure dopée présentant une proportion d'indium x1≥0 ; et une portion supérieure réalisée à base d'Inₓ₂Ga₁₋ₓ₂N avec x2>x1 et présentant un niveau de dopage inférieur à celui de la portion inférieure, et reposant sur et au contact de la portion inférieure ; les mésas étant configurées de sorte que :
   - les portions inférieure et supérieure de la mésa M₍₀₎ sont non poreuses ;
   - seule une portion parmi les portions inférieure et supérieure de la mésa M₍₁₎ est poreuse ;
   - les portions inférieure et supérieure de la mésa M₍₂₎ sont poreuses

Chaque mésa M₍ᵢ₎ peut comporter une portion de reprise d'épitaxie reposant sur la portion supérieure, réalisée à base d'InGaN cristallin non poreux dont le paramètre de maille a^{m}_{cre} du matériau relaxé est supérieur au paramètre de maille effectif a^{e}_{cs} de la couche support : la portion de reprise d'épitaxie de chaque mésa M₍₂₎ présentant un paramètre de maille maximal a^{e}_{cre(2)} ; la portion de reprise d'épitaxie de chaque mésa M₍₀₎ présentant un paramètre de maille a^{e}_{cre(0)} inférieur à a^{e}_{cre(2)} ; la portion de reprise d'épitaxie de chaque mésa M₍₁₎ présentant un paramètre de maille intermédiaire a^{e}_{cre(1)} inférieur à a^{e}_{cre(2)} et différent de a^{e}_{cre(0)}.

Les portions inférieures des mésas M₍ᵢ₎ peuvent reposer sur une couche continue réalisée en un matériau électriquement conducteur.

L'invention porte également sur un dispositif optoélectronique (1) comportant : un substrat de croissance selon l'une quelconque des caractéristiques précédentes ; et une matrice de diodes D₍ᵢ₎ à base d'InGaN, épitaxiées à partir des mésas du substrat de croissance, les diodes étant adaptées à émettre ou à détecter un rayonnement lumineux à différentes longueurs d'onde, la longueur d'onde étant différente d'une catégorie de mésas M₍ᵢ₎ à l'autre.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :
les figures 1A à 1C sont des vues schématiques et partielles, en coupe transversale, d'un substrat de croissance comportant des mésas ayant différents niveaux de porosification, selon différentes variantes de réalisation, ainsi qu'une matrice de diodes à base d'InGaN épitaxiées à partir du substrat de croissance ;
la figure 2 illustre un exemple de relation entre le niveau de dopage d'une couche cristalline dopée en fonction de la tension électrique appliquée, mettant en évidence le domaine d'existence de la porosification électrochimique ;
les figures 3A à 3E illustrent différentes étapes d'un procédé de fabrication d'un substrat de croissance similaire à celui de la fig.1A, puis d'une matrice de diodes, comportant une étape de porosification électrochimique photo-assistée (PECE) des portions supérieures suivie d'une étape de porosification électrochimique non photo-assistée (ECE) des portions inférieures ;
les figures 4A à 4E illustrent différentes étapes d'un procédé de fabrication d'un substrat de croissance similaire à celui de la fig.1B, puis d'une matrice de diodes, comportant également une étape de porosification électrochimique photo-assistée PECE suivie d'une étape de porosification électrochimique non photo-assistée ECE ;
les figures 5A à 5D illustrent différentes étapes d'un procédé de fabrication d'un substrat de croissance similaire à celui de la fig.1B, puis d'une matrice de diodes, dans lequel les portions inférieures et des portions supérieures sont porosifiées de manière concomitante ;
les figures 6A à 6D illustrent différentes étapes d'un procédé de fabrication d'un substrat de croissance similaire à celui de la fig.1C, puis d'une matrice de diodes, dans lequel les portions inférieures et des portions supérieures sont porosifiées de manière concomitante.

### EXPOSÉ DÉTAILLÉ DE MODES DE RÉALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux. Sauf indication contraire, les termes « sensiblement », « environ », « de l'ordre de » signifient à 10% près, et de préférence à 5% près. Par ailleurs, les termes « compris entre ... et ... » et équivalents signifient que les bornes sont incluses, sauf mention contraire.

L'invention porte sur un substrat de croissance et son procédé de fabrication. Le substrat de croissance est adapté à la réalisation par épitaxie d'une matrice de diodes à base d'InGaN, les diodes permettant d'émettre ou de détecter, de manière native, un rayonnement lumineux à différentes longueurs d'onde.

Le substrat de croissance comporte des mésas M₍ᵢ₎ avec i allant de 0 à 2, ayant différents niveaux de porosification P₍ᵢ₎ selon que les portions inférieure et supérieure des mésas sont toutes poreuses (mésas notées M₍₂₎), ou seulement l'une d'entre elles (mésas M₍₁₎), voire aucune (mésas M₍₀₎). Ces différents niveaux de porosification P₍ᵢ₎ permettent d'obtenir des mésas M₍ᵢ₎ ayant différents taux de relaxation R₍ᵢ₎. Les taux de relaxation R₍ᵢ₎ se traduisent par le fait que les portions de reprise d'épitaxie présentent différentes valeurs du paramètre de maille effectif d'une catégorie de mésa à l'autre. Aussi, les diodes D₍ᵢ₎, réalisées lors d'une même étape d'épitaxie, présentent des zones actives différentes en termes de proportion d'indium incorporé dans les puits quantiques, d'une catégorie de diodes D₍ᵢ₎ à l'autre (et donc de mésas) et sont donc adaptées à émettre ou détecter un rayonnement lumineux à différentes longueurs d'onde.

Notons que les portions inférieure et supérieure des mésas sont au contact l'une de l'autre, et ne sont pas séparées l'une de l'autre par une couche intermédiaire d'isolation qui permettrait de ne porosifier que l'une ou l'autre desdites portions de la mésa. Dans cette configuration, la porosification des portions inférieure et supérieure des mésas est rendue possible par la mise en œuvre d'une porosification électrochimique différenciée des portions inférieure et supérieure des mésas, au moyen d'une porosification photo-assistée de la portion supérieure (on parle alors d'une porosification PECE, pour *Photo ElectroChemical Etching* en anglais) et d'une porosification non photo-assistée de la portion inférieure (on parle alors d'une porosification ECE, pour *ElectroChemical Etching,* en anglais).

Pour cela, pour chaque mésa, la portion inférieure est suffisamment dopée pour être porosifiable par porosification ECE pour une tension électrique appliquée de valeur V_{ECE} prédéfinie. En revanche, la portion supérieure est non intentionnellement dopée ou insuffisamment dopée pour être non porosifiable lors de la porosification ECE à la tension électrique V_{ECE}. De préférence, il y a une différence d'au moins un ordre de grandeur, en termes de niveau de dopage, entre la portion inférieure et la portion supérieure.

De plus, pour chaque mésa, la portion supérieure présente une proportion d'indium x2>0 suffisante pour qu'elle absorbe le rayonnement lumineux d'illumination de la longueur d'onde centrale λ_{c} émis en direction des mésas lors de la porosification PECE En revanche, la portion inférieure est réalisée en un matériau dont la proportion d'indium x1≥0 est insuffisante pour qu'elle absorbe ce rayonnement lumineux d'illumination lors de la porosification PECE.

Rappelons que la porosification par anodisation électrochimique est effectuée en plongeant le substrat de croissance à base de GaN cristallin dans un électrolyte liquide. Dans le cadre de la porosification ECE, le substrat de croissance est connecté à l'anode d'un générateur électrique alors qu'une contre-électrode, plongée dans l'électrolyte, est connectée à la cathode, pour ainsi appliquer une tension électrique de valeur V_{ECE} prédéfinie.

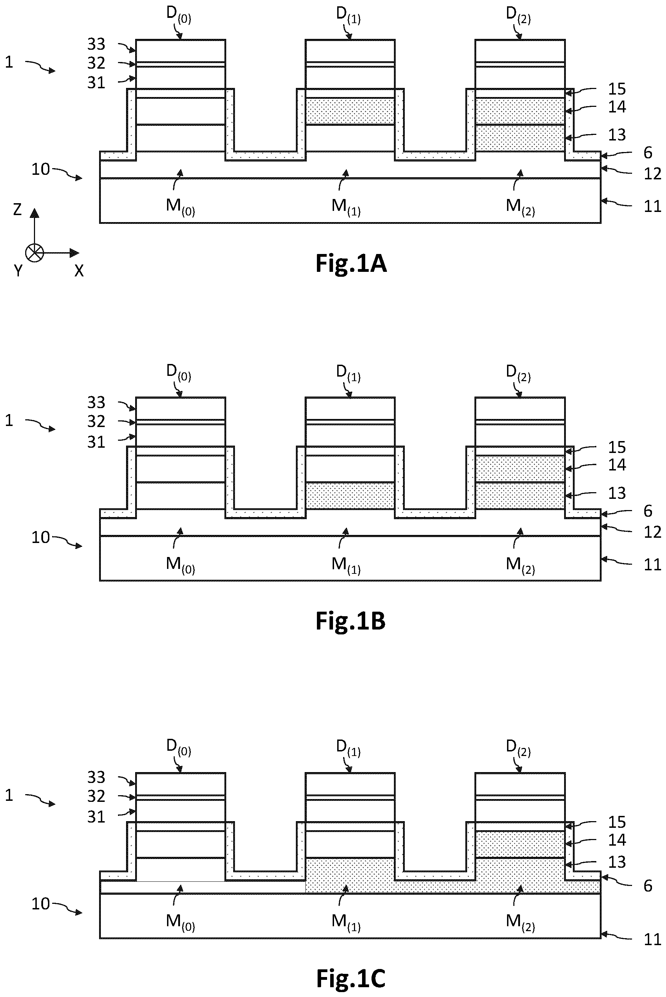

Les figures 1A à 1C sont des vues schématiques et partielles, en coupe transversale, d'un dispositif optoélectronique 1 comportant un substrat de croissance 10 et une matrice de diodes D₍ᵢ₎ à base d'InGaN, selon différentes variantes de réalisation. Les figures 1A et 1B illustrent des variantes où les mésas M₍ᵢ₎ reposent sur une même couche tampon 12 réalisée en un matériau non porosifiable (à la tension électrique de porosification des mésas) et électriquement conducteur, alors que la figure 1C illustre une variante où une telle couche tampon 12 est absente.

Le dispositif optoélectronique 1 est ici un micro-écran à émission native RGB, où le pas des diodes D₍ᵢ₎ peut être inférieur ou égal à 10µm environ. L'indice i, allant de 0 à 2, est relatif aux catégories (présentées plus loin) des mésas M₍ᵢ₎ et donc des diodes D₍ᵢ₎.

On définit ici et pour la suite de la description un repère direct tridimensionnel orthogonal XYZ, où les axes X et Y forment un plan principal d'une couche support 11 et où l'axe Z est orienté suivant l'épaisseur du substrat de croissance 10 en direction des diodes D₍ᵢ₎.

Le dispositif optoélectronique 1 comporte un substrat de croissance 10 à partir duquel une matrice de diodes D₍ᵢ₎ a été réalisée par épitaxie. Les électrodes de polarisation électrique des diodes ne sont pas représentées ici dans un souci de clarté.

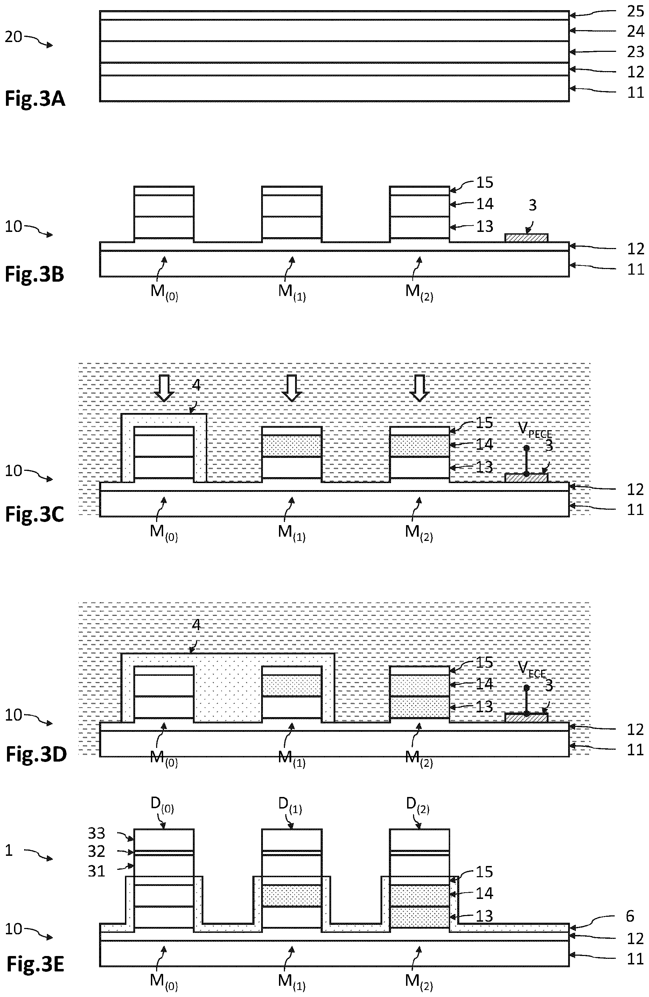

Le substrat de croissance 10 comporte une couche support 11 et des mésas M₍ᵢ₎ destinées chacune à la réalisation par reprise d'épitaxie d'une diode D₍ᵢ₎ de la matrice. Une mésa (i.e. une élévation, un relief) est une partie du substrat de croissance 10 en saillie vis-à-vis de la couche support 11. Les mésas sont réalisées par gravure localisée d'un empilement cristallin 20 (cf. fig.3A).

Le substrat de croissance 10 est réalisé à partir de GaN cristallin, c'est-à-dire qu'il est réalisé en GaN et/ou en ses composés tels que l'InₓGa₁₋ₓN, l'Al_{y}Ga_{1-y}N, voire l'InₓAl_{y}Ga_{1-x-y}N. D'une manière générale, par « matériau à base de GaN », on entend que le matériau peut être du GaN et/ou ses composés. Il peut ainsi être de l'InₓAl_{y}Ga_{1-x-y}N où la proportion d'indium x peut être nulle et où la proportion d'aluminium y peut également être nulle. Et « par matériau à base d'InGaN », on entend qu'il est en InGaN ou en InAlGaN, c'est-à-dire qu'il peut être réalisé en l'InₓAl_{y}Ga_{1-x-y}N où la proportion d'indium x est non nulle et où la proportion d'aluminium y peut être nulle.

La couche support 11 est réalisée ici en un matériau non porosifiable, de sorte qu'il reste non poreux (dense) lors de la porosification des mésas. Il peut s'agir d'un matériau inerte à la réaction électrochimique de porosification, tel qu'un matériau isolant (saphir...) ou un matériau semiconducteur (SiC, Si...) non intentionnellement dopé (nid) ou faiblement dopé. Il peut également s'agir d'un matériau semiconducteur à base de GaN dont le niveau de dopage N_{D} est inférieur à une valeur minimale N_{D,min}(V_{ECE}) de la tension électrique appliquée lors de la porosification ECE (non photo-assistée) : il peut alors être non intentionnellement dopé ou faiblement dopé. De préférence, la couche support est non porosifiable à la tension électrique de porosification des mésas. A titre d'exemple, la couche support peut être réalisée en saphir, en silicium, en SiC, en GaN autoportant *(freestanding* en anglais), entre autres. Elle présente une épaisseur par exemple comprise entre 200µm et 1.2mm environ. Des couches intermédiaires peuvent être présentes entre la couche support 11 et la couche tampon 12, réalisées par exemple à base d'AlN. Ainsi, à titre d'exemples, on peut utiliser les empilements suivants : Si/AlN/AlGaN/GaN ; saphir/GaN nid ; SiC/AlN/AlGaN etc...

Une couche tampon 12 peut être présente, comme l'illustrent les fig.1A et 1B. La couche tampon 12 permet ici d'appliquer un potentiel électrique aux portions inférieures 13 des mésas M₍ᵢ₎ à partir d'une électrode de polarisation 3 (cf. par exemple fig.3B). En effet, les portions inférieures 13 sont ici distinctes les unes des autres dans le plan XY (pas de continuité du matériau de ces portions inférieures). Pour cela, la couche tampon 12 est réalisée en un matériau cristallin à base de GaN dopé (ici de type n) sur au moins une partie de son épaisseur. La couche tampon 12 est réalisée par épitaxie à partir de la couche support 11. Elle peut présenter une épaisseur comprise entre 1 et 10µm environ.

La couche tampon 12 peut être réalisée en un matériau non porosifiable lors des porosification ECE et PECE. Il est alors faiblement dopé pour, d'une part permettre le transport des porteurs de charge, et d'autre part ne pas être porosifiable lors de la porosification ECE. Plus précisément, il présente un niveau de dopage N_{D} inférieur à une valeur minimale prédéfinie N_{D,min}(V_{ECE}) du niveau de dopage N_{D} à partir de laquelle, pour une valeur V_{ECE} de tension électrique appliquée lors d'une porosification ECE, un matériau cristallin à base de GaN est porosifié. Le niveau de dopage N_{D} peut être inférieur à 10¹⁸ cm⁻³ pour une valeur V_{ECE} de la tension électrique de l'ordre de 30V environ. De plus, pour ne pas être porosifiable lors de la porosification PECE, la couche tampon 12 présente une proportion d'indium insuffisante pour absorber le rayonnement lumineux d'illumination. En variante, la couche tampon 12 peut être réalisée en un matériau porosifiable lors de la polarisation ECE.

En variante, comme l'illustre la fig.1C, la couche tampon 12 peut être absente. Aussi, le substrat de croissance 10 comporte une couche continue inférieure 23 à partir de laquelle sont formées les portions inférieures 13 des mésas M₍ᵢ₎. Autrement dit, cette couche inférieure 23 s'étend continûment dans le plan XY et raccorde les portions inférieures 13 entre elles. L'électrode de polarisation 3 repose alors au contact de la couche inférieure 23.

Les mésas M₍ᵢ₎ comportent deux portions superposées suivant l'axe Z, au contact l'une sur l'autre, à savoir une portion inférieure 13 située du côté de la couche support 11, et une portion supérieure 14 qui repose sur et au contact de la portion inférieure 13. Elles sont réalisées en un matériau porosifiable de manière différenciée, selon qu'il s'agisse d'une porosification électrochimique non photo-assistée ECE ou d'une porosification électrochimique photo-assistée PECE. Une portion de reprise d'épitaxie 15 réalisée à base d'InGaN repose sur la portion supérieure 14. Elle peut être réalisée avant ou après la porosification électrochimique des mésas M₍ᵢ₎.

Chacune des portions inférieures 13 et supérieures 14 est réalisée en un matériau semiconducteur cristallin à base de GaN. Le matériau peut être choisi parmi l'InGaN, l'AlGaN, l'InAlGaN, et/ou le GaN. Dans cet exemple, les portions inférieures 13 sont réalisées en GaN, et les portions supérieures 14 sont réalisées en InGaN. Elles présentent une épaisseur par exemple comprise entre 50nm et 1µm environ, ici égale à 800nm environ. Les portions inférieures 13 et supérieures 14 d'une même mésa M₍ᵢ₎ peuvent présenter une même épaisseur ou une épaisseur différente. Les mésas M₍ᵢ₎ peuvent avoir été formées par une ou plusieurs opérations de gravure d'un empilement cristallin initial (cf. par exemple la fig.3A), par exemple par gravure sèche, de sorte que leurs flancs peuvent être sensiblement verticaux.

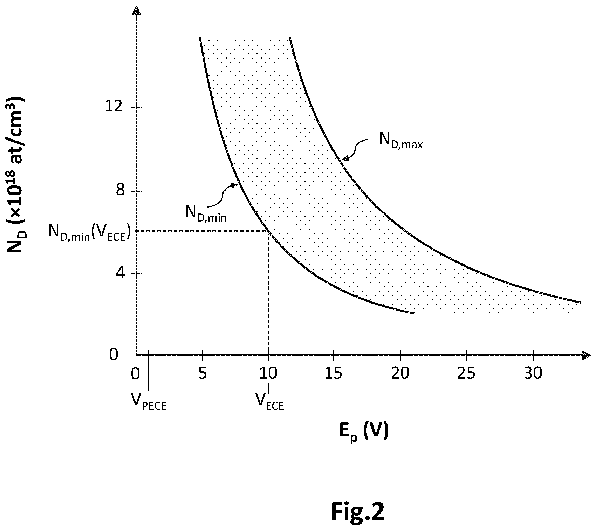

Rappelons ici qu'une réaction de porosification électrochimique est une réaction sélective dans le sens où, pour une même tension électrique Eₚ de valeur V_{ECE}, un matériau semiconducteur cristallin dopé à base de GaN sera porosifié si son niveau de dopage N_{D} est supérieur ou égal à un niveau de dopage minimal N_{D,min}(V_{ECE}) prédéfini. Dans le cas contraire, il ne sera pas porosifié et restera intègre (dense). A ce titre, la figure 2 illustre un exemple du domaine d'existence de la porosification électrochimique en fonction du niveau de dopage N_{D} (ici en donneurs) du matériau cristallin à base de GaN et de la tension électrique Eₚ appliquée, tel que décrit notamment dans le document EP3840016A1.

Le niveau de dopage minimal N_{D,min} dépend de la valeur de la tension électrique Eₚ selon une fonction décroissante : plus la tension électrique Eₚ est élevée, moins le niveau de dopage minimal N_{D,min} requis pour porosifier le matériau cristallin est élevé. Autrement dit, pour une valeur prédéfinie V_{ECE} de la tension électrique Eₚ appliquée lors de l'étape de porosification ECE, le matériau cristallin ayant un niveau de dopage N_{D} inférieur à la valeur minimale Nₘᵢₙ(V_{ECE}) ne sera pas porosifié (rendu poreux) et restera donc intègre ou dense (non poreux) : ce matériau peut donc être qualifié de « non porosifiable ». En revanche, ce même matériau, lorsqu'il présente un niveau de dopage N_{D} au moins égal à la valeur minimale N_{D,min}(V_{ECE}), sera porosifié (rendu poreux) et peut donc être qualifié de « porosifiable ». Notons que le domaine d'existence dépend également de la bande d'énergie interdite du matériau, et donc ici de la proportion d'indium du matériau. En effet, plus cette proportion d'indium est importante dans le matériau, plus le potentiel de porosification est faible. Aussi, il est préférable que la proportion d'indium de la portion supérieure 14 ne soit pas beaucoup plus élevée (par ex. de l'ordre de 2%) que celle de la portion inférieure 13 (par ex. de l'ordre de 0% pour du GaN).

La porosification de toutes les portions inférieure et supérieure des mésas M₍ᵢ₎, ou de seulement l'une d'entre elles, permet d'obtenir une relaxation plus ou moins importante au sein des mésas M₍ᵢ₎. Ainsi, une portion porosifiée devient déformable, et autorisera une relaxation partielle ou totale de la portion supérieure(s) non poreuse(s), qu'il s'agisse de la portion supérieure 14 si elle est non poreuse et/ou de la portion de reprise d'épitaxie 15. Aussi, le substrat de croissance 10 peut présenter les caractéristiques suivantes :
o dans les mésas M₍₂₎ où le niveau de porosification P₍₂₎ est maximal, le fait que toutes les portions inférieure 13 et supérieure 14 soient devenues poreuses les rend déformables vis-à-vis des contraintes mécaniques générées par la portion de reprise d'épitaxie 15, de sorte que celle-ci se relaxe et présente un paramètre de maille effectif a^{e}_{cre(2)} pouvant alors être sensiblement égal à celui de son matériau massif a^{m}_{cre} : a^{e}_{cre(2)} ≈ a^{m}_{cre} ;
o dans les mésas M₍₀₎ où le niveau de porosification P₍₀₎ est minimal, comme aucune des portions inférieure 13 et supérieure 14 n'ait été rendue poreuse et donc déformable, la portion de reprise d'épitaxie 15 continue de subir les contraintes mécaniques générées par la couche support 11 ou par la couche tampon 12 (le cas échéant), et présente donc un paramètre de maille effectif a^{e}_{cre(0)} pouvant être sensiblement égal (moyennant une légère relaxation due à la gravure de la mésa) à celui de la couche tampon 12 : a^{e}_{cre(0)} ≈ a^{e}_{ct};
o dans les mésas M₍₁₎ où le niveau de porosification P₍₁₎ est intermédiaire, une portion porosifiée sera donc rendue déformable et permettra à la portion supérieure non poreuse (la portion supérieure 14 et/ou la portion de reprise d'épitaxie 15) de relaxer en partie :
   - si la portion poreuse est la portion inférieure 13 et que la portion supérieure 14 est non poreuse et est réalisée en InGaN, ou si la portion poreuse est la portion supérieure 14, alors la portion de reprise d'épitaxie 15 présente un paramètre de maille effectif a^{e}_{cre(1)} qui pourra être supérieur à a^{e}_{cre(0)}. On pourra alors avoir un substrat de croissance 10 où : a^{e}_{cre(0)} < a^{e}_{cre(1)} < a^{e}_{cre(N)}.

Les portions inférieures 13 des mésas M₍ᵢ₎ sont réalisées en un matériau qui est porosifiable lors de la porosification électrochimique non photo-assistée ECE, et qui est non porosifiable lors de la porosification électrochimique photo-assistée PECE.

Ainsi, pour être porosifiable lors de la porosification ECE au cours de laquelle une tension électrique Eₚ de valeur V_{ECE} est appliquée au substrat de croissance 10, le matériau des portions inférieures 13 présente un niveau de dopage N_{D} au moins égal à la valeur minimale V_{D,min}(V_{ECE}) à partir de laquelle la porosification du matériau a lieu, par exemple compris entre 3×10¹⁸cm⁻³ et 1.5×10¹⁹cm⁻³, par exemple égal à 6×10¹⁸cm⁻³ environ. Les portions inférieures 13 sont de préférence dopées de type n au silicium, voire également au germanium, mais un dopage de type p est possible.

De plus, pour être non porosifiable lors de la porosification PECE au cours de laquelle un rayonnement lumineux d'illumination de longueur d'onde λ_{c} est émis en direction des mésas, le matériau présente une proportion d'indium x1≥0 telle que le rayonnement lumineux d'illumination n'est pas absorbé. La proportion d'indium x1 des portions inférieures 13 est telle que le rayonnement lumineux d'illumination n'est pas absorbé, même en prenant en compte l'effet Franz Keldysh. Elle est de préférence inférieure à la proportion d'indium x2 des portions supérieures 14.

Par ailleurs, les portions supérieures 14 des mésas M₍ᵢ₎ sont réalisées en un matériau non porosifiable lors de la porosification électrochimique non photo-assistée ECE, mais est porosifiable lors de la porosification électrochimique photo-assistée PECE.

Ainsi, pour être non porosifiable lors de la porosification ECE, le matériau des portions supérieures 14 présente un niveau de dopage N_{D} inférieur à la valeur minimale V_{D,min}(V_{ECE}) à partir de laquelle la porosification du matériau a lieu. Les portions supérieures 14 peuvent être non intentionnellement dopées mais de préférence sont faiblement dopées, et par exemple peuvent présenter un niveau de dopage au plus égal à 5×10¹⁷ cm⁻³. Le dopage peut être de type n, comme pour les portions inférieures.

De plus, pour être porosifiable lors de la porosification PECE, le matériau présente une proportion d'indium x2>0 suffisante pour absorber le rayonnement lumineux d'illumination au niveau des pores. Notons ici que l'absorption du rayonnement lumineux d'illumination par les portions supérieures 14 peut reposer sur l'effet Franz-Keldysh, comme mentionné notamment dans l'article de Toguchi et al. intitulé Anisotropic Electrochemical Etching pf Porous Gallium Nitride by Sub-Bandgap Absorption Due to Franz-Keldysh Effect, J. Electrochem. Soc. 2019, 166, H510. En effet, la longueur d'onde centrale λ_{c} est légèrement inférieure à l'énergie de bande interdite du matériau des portions supérieures 14, mais la présence d'un champ électrique au niveau des pores en formation autorise l'absorption du rayonnement lumineux d'illumination. Ainsi, la portion supérieure 14 est porosifiée et non pas entièrement gravée.

Par ailleurs, chaque mésa M₍ᵢ₎ du substrat de croissance 10 peut comporter une portion de reprise d'épitaxie 15 qui repose sur la portion supérieure 14. Elle peut être réalisée avant la porosification des mésas M₍ᵢ₎, ou après celle-ci, par exemple lors de la fabrication de la matrice de diodes D₍ᵢ₎. Elle est réalisée en un matériau cristallin à base d'InGaN qui peut être choisi parmi l'InGaN et l'InAlGaN, et est destinée à permettre la réalisation des diodes D₍ᵢ₎ par reprise d'épitaxie. Elle est réalisée ici par épitaxie à partir des portions supérieures 14. Notons que, si la portion de reprise d'épitaxie 15 est réalisée en GaN, elle peut être déposée avant ou après la porosification des mésas.

Dans le cas où les portions de reprise d'épitaxie 15 sont réalisées avant la porosification électrochimique des mésas M₍ᵢ₎, elle est réalisée en un matériau non porosifiable lors de la porosification ECE et lors de la porosification PECE.

Aussi, pour être non porosifiable lors de la porosification ECE, le matériau des portions de reprise d'épitaxie 15 présente un niveau de dopage N_{D} inférieur à la valeur minimale V_{D,min}(V_{ECE}) à partir de laquelle la porosification du matériau a lieu. De préférence, les portions de reprise d'épitaxie 15 peuvent être non intentionnellement dopées (par exemple de l'ordre de 10¹⁷ cm⁻³) mais de préférence sont faiblement dopées, et par exemple peuvent présenter un niveau de dopage au plus égal à 5×10¹⁷ cm⁻³. Le dopage peut être de type n, comme pour les portions inférieures.

De plus, pour être non porosifiable lors de la porosification PECE, le matériau des portions de reprise d'épitaxie 15 présente une proportion d'indium x3 telle que le rayonnement lumineux d'illumination n'est pas absorbé. La proportion d'indium x3 est inférieure à la proportion d'indium x2 des portions supérieures 14. Dans le cas où les portions de reprise d'épitaxie 15 sont réalisées en InGaN, elles sont déposées de préférence après la porosification des mésas, pour ainsi ne pas être contraintes en termes de proportion d'indium x3 vis-à-vis de la porosification PECE.

En variante, dans le cas où les portions de reprise d'épitaxie 15 sont réalisées après la porosification électrochimique des mésas M₍ᵢ₎, peu importe qu'elles soient réalisées en un matériau porosifiable ou non. Notons que dans ce dernier cas, les portions dopées 31 de la jonction semiconductrice des diodes D₍ᵢ₎ peuvent correspondre aux portions de reprise d'épitaxie 15.

Les portions de reprise d'épitaxie 15 présentent une épaisseur et une proportion d'indium x3 non nulle telle qu'elle participe à obtenir les taux de relaxation souhaités R₍ᵢ₎ pour les mésas M₍₁₎ et M₍₂₎, comme expliqué en détail plus loin. A titre d'exemple, elle présente une épaisseur de 200nm environ et une proportion d'indium x3 au moins égale à 8%. Elle peut présenter une épaisseur moindre, par exemple de 100nm environ, et une proportion d'indium x3 plus élevée, par exemple de 12% environ.

Notons ici que les portions inférieures 13 et supérieures 14 (et les portions de reprise d'épitaxie 15, si elles sont réalisées avant la porosification électrochimique) présentent chacune une épaisseur inférieure à son épaisseur critique à laquelle il y a une relaxation plastique des contraintes mécaniques. L'épaisseur totale de l'empilement de ces portions est également inférieure à une épaisseur critique prédéfinie. Ainsi, la couche support 11 génère, dans les portions inférieures 13 et supérieures 14, des contraintes mécaniques (orientées dans le plan XY) dont la valeur est telle que, avant porosification, le paramètre de maille au niveau de la face supérieure des mésas M₍ᵢ₎ est proche ou sensiblement égal au paramètre de maille effectif a^{e}_{cs} de la couche support 11.

Dans la mesure où les mésas M₍ᵢ₎ sont réalisées à partir du même empilement cristallin initial 20, chaque portion d'une mésa M₍ᵢ₎ est coplanaire avec les portions correspondantes des autres mésas. Ainsi, les portions de reprise d'épitaxie 15 sont coplanaires entre elles et définissent des faces supérieures également coplanaires. Les portions supérieures 14 sont coplanaires entre elles. Il en est de même pour les portions inférieures 13.

De plus, chaque portion d'une mésa M₍ᵢ₎ présente une épaisseur identique à celle des portions correspondantes des autres mésas. Ainsi, les portions de reprise d'épitaxie 15 présentent une même épaisseur entre elles. Il en est de même pour les portions inférieures 13, et pour les portions supérieures 14.

A titre illustratif, dans l'exemple de la fig.1A, le substrat de croissance 10 comporte une couche tampon 12 en GaN contraint par la couche support 11 en saphir (paramètre de maille ici de 3.184Â). Les mésas M₍ᵢ₎ comportent chacun : une portion inférieure 13 à base de GaN dopé de type n, une portion supérieure en Inₓ₂Ga₁₋ₓ₂N avec x2>0. Dans cet exemple, la portion de reprise d'épitaxie 15 est réalisée en Inₓ₃Ga₁₋ₓ₃N d'une épaisseur de 200nm environ et une proportion d'indium x3 égale à 8% environ. Elle est réalisée avant la porosification électrochimique des mésas M₍ᵢ₎.

La mésa M₍₀₎ présente un taux de relaxation minimal R₍₀₎ de sorte que la portion de reprise d'épitaxie 15 présente un paramètre de maille proche ou sensiblement égal à celui (3.184Â) de la couche support 11. La mésa M₍₂₎ présente un taux de relaxation maximale R₍₂₎ de sorte que la portion de reprise d'épitaxie 15 présente un paramètre de maille proche ou sensiblement égal à celui de l'In_{0.15}Ga_{0.85}N massif (3.238Â environ) qui aurait été déposé ensuite sur la mésa, du fait de la déformation élastique des portions inférieure 13 et supérieure 14 poreuses. La mésa M₍₁₎ présente un taux de relaxation intermédiaire R₍₁₎ de sorte que la couche de reprise d'épitaxie 15 présente un paramètre de maille compris entre 3.184Â et 3.217Å. On a donc a^{e}_{cre(0)} < a^{e}_{cre(1)} < a^{e}_{cre(2)}. Ainsi, la matrice de diodes peut alors comporter des diodes D₍₀₎ émettant dans le bleu, des diodes D₍₁₎ᵤ émettant dans le vert, et des diodes D_{(N)} émettant dans le rouge.

Ainsi, le substrat de croissance 10 comporte des mésas de différentes catégories M₍ᵢ₎ présentant des niveaux de porosification P₍ᵢ₎ différents, autorisant des taux de relaxation R₍ᵢ₎ différents. Un tel substrat de croissance 10 permet alors de réaliser une matrice de diodes D₍ᵢ₎ adaptées à émettre ou à recevoir, de manière native, un rayonnement lumineux à différentes longueurs d'onde. Ce substrat de croissance 10 est obtenu à partir d'un empilement cristallin original 20 fait de deux couches inférieure 23 et supérieure 24, au contact l'une de l'autre, et non pas séparées deux à deux par une couche isolante. Ces différents niveaux de porosification sont obtenus par la mise en œuvre d'une porosification électrochimique différenciée des portions inférieures 13 et supérieures 14 des mésas M₍ᵢ₎. On obtient ainsi les différentes catégories de mésas M₍ᵢ₎, sans qu'il soit nécessaire de réaliser des étapes d'implantation spatialement localisée de dopants comme dans le procédé de fabrication de l'art antérieur mentionné précédemment. L'absence d'une couche isolante dans les mésas autorise alors de polariser électriquement les diodes par le substrat de croissance 10.

Les figures 3A à 3E illustrent différentes étapes d'un procédé de fabrication d'un substrat de croissance 10 similaire à celui de la fig.1A, puis d'une matrice de diodes D₍ᵢ₎. Dans cet exemple, les diodes sont électroluminescentes et forment un micro-écran à émission native RGB. Le procédé de fabrication met en œuvre une porosification PECE de portions supérieures 14 des mésas M₍ᵢ₎, suivies d'une porosification ECE de portions inférieures 13.

En référence à la fig.3A, on fournit tout d'abord un empilement cristallin 20 comportant, sur une couche support 11 qui s'étend dans le plan principal XY : une couche tampon 12, une couche continue inférieure dopée 23, une couche continue supérieure 24, et ici une couche continue de reprise d'épitaxie 25. Ces couches s'étendent dans le plan XY de manière continue sur toute l'étendue de la couche support 11. Les différentes couches sont obtenues par des étapes successives d'épitaxie à partir de la couche support 11.

En référence à la fig.3B, on réalise ici une gravure localisée de l'empilement cristallin 20 de manière à former les mésas M₍ᵢ₎. On grave ainsi, de préférence par gravure sèche, la couche continue de reprise d'épitaxie 25 pour former des portions de reprise d'épitaxie 15, la couche continue supérieure 24 pour former des portions supérieures 14, la couche continue inférieure 23 pour former des portions inférieures 13, et déboucher ici dans la couche tampon 12. Les portions inférieures 13 sont donc distinctes les unes des autres dans le plan XY (pas de continuité de matière). La gravure peut notamment être réalisée par un procédé de type plasma ICP-RIE en gaz chloré. Les mésas M₍ᵢ₎ sont donc séparées deux à deux dans le plan XY par une tranchée. On dépose ensuite une électrode 3 sur et au contact de la couche tampon 12, qui permet d'appliquer un potentiel électrique aux mésas M₍ᵢ₎.

Notons que, en variante (non représentée), la tranchée peut séparer les mésas M₍ᵢ₎ d'une catégorie à l'autre. En revanche, les mésas d'une même catégorie peuvent être séparées deux à deux par une tranchée moins profonde. Elles peuvent ainsi être raccordées physiquement par une partie non gravée de la couche inférieure 23.

En référence à la fig.3C, on effectue une première étape de porosification électrochimique des mésas M₍ᵢ₎. Il s'agit ici de porosifier certaines portions supérieures 14 de manière photo-assistée. Les couches inférieure 23 et supérieure 24 ont été configurées en termes de proportion d'indium (respectivement x1 et x2) de sorte que, lors de la porosification PECE où un rayonnement lumineux d'illumination de longueur d'onde centrale λ_{c} prédéfinie est émis en direction des mésas M₍ᵢ₎, les portions supérieures 14 peuvent être porosifiées, alors que les portions inférieures 13 ne sont pas porosifiées. De plus, dans cet exemple où les portions de reprise d'épitaxie 15 sont réalisées avant la porosification, le matériau de ces portions 15 a été réalisé en termes de proportion d'indium x3 de manière à ne pas être porosifié lors de la porosification PECE.

Mais avant cela, dans le but d'obtenir des mésas M₍₀₎ ayant un niveau de porosification P₍₀₎, c'est-à-dire qu'aucune des portions inférieures 13 et supérieures 14 ne seront porosifiées lors des porosifications PECE et ECE, on encapsule les mésas M₍₀₎ dans une couche d'encapsulation 4 réalisée en un matériau électriquement isolant comme une résine photosensible ou une couche d'un oxyde ou d'un nitrure de silicium. Ainsi, les portions inférieures 13 et supérieures 14 des mésas M₍₀₎ ne seront pas au contact de l'électrolyte liquide. La couche d'encapsulation 4 peut être transparente au rayonnement lumineux d'illumination : dans la mesure où les mésas M₍₀₎ ne seront pas au contact de l'électrolyte liquide, il n'y aura pas de porosification PECE. En revanche, les mésas M₍₁₎ et M₍₂₎ ne sont pas recouvertes par cette couche d'encapsulation 4, de manière à être ensuite au contact de l'électrolyte liquide.

Ensuite, on plonge le substrat de croissance dans un électrolyte liquide. L'électrode de polarisation 3 peut être connectée, ou non, au générateur électrique. Elle permet de collecter les électrons photo-générés. De préférence, pour améliorer la collection de ces électrons, on applique une tension électrique de valeur V_{PECE}, laquelle est suffisamment faible pour ne pas générer une porosification ECE, par exemple 1 à 2V inférieure à la valeur V_{ECE}. La valeur de la tension électrique V_{PECE} peut être diminuée en ajustant la longueur d'onde du rayonnement incident. Une électrode de référence peut être présente pour contrôler précisément la tension électrique appliquée. Pour cela, l'électrode de polarisation 3 est connectée à l'anode du générateur électrique, le substrat de croissance 10 formant alors une électrode de travail. Une contre-électrode (ici un fil en platine) est plongée dans l'électrolyte, et est raccordée à la cathode du générateur électrique. Le générateur électrique applique une tension électrique Eₚ de valeur V_{PECE}. L'électrolyte liquide peut être acide ou basique, et peut être de l'acide oxalique. Il peut également s'agir de KOH, HF, HNO₃, NaNO₃, H₂SO₄ ou de leur mélange. On peut ainsi utiliser également un mélange d'acide oxalique et de NaNO₃.

De plus, on émet un rayonnement lumineux d'illumination, de longueur d'onde centrale λ_{c}, en direction des mésas M₍ᵢ₎. Aussi, le rayonnement lumineux d'illumination est absorbé par les portions supérieures 14 des mésas M₍₁₎ et M₍₂₎ au niveau des pores (et non pas de manière massive) pour obtenir une porosification des portions et non pas une gravure totale de celles-ci. Dans cet exemple, il peut également être absorbé par la portion supérieure des mésas M₍₀₎ si la couche d'encapsulation 4 est transparente à la longueur d'onde λ_{c}. Aussi, des paires électrons-trous sont photo-générées. Les électrons sont alors collectés par l'électrode de polarisation 3, et les trous sont utilisés pour l'oxydation du matériau des portions supérieures 14 des mésas M₍₁₎ et M₍₂₎ qui sont au contact de l'électrolyte liquide. Aussi, les portions supérieures 14 des mésas M₍₁₎ et M₍₂₎ sont porosifiées de manière photo-assistée. En revanche, les mésas M₍₀₎ ne sont pas porosifiées car elles ne sont pas au contact de l'électrolyte liquide. Notons que les portions inférieures 13 des mésas M₍₁₎ et M₍₂₎ ainsi que la couche tampon 12 ne sont pas porosifiées car elles sont réalisées en un matériau non porosifiable à la tension électrique V_{PECE}. Une fois les portions supérieures 14 des mésas M₍₁₎ et M₍₂₎ porosifiées, on retire le substrat de croissance du bain électrolytique.

En référence à la fig.3D, on effectue une deuxième étape de porosification électrochimique des mésas M₍ᵢ₎. Il s'agit ici de porosifier les portions inférieures 13 des mésas M₍₂₎ de manière non photo-assistée, sans porosifier celles des mésas M₍₁₎. La couche inférieure 23 a été configurée en termes de niveau de dopage de sorte que, lors de la porosification ECE, les portions inférieures 13 peuvent être porosifiées si elles sont au contact de l'électrolyte liquide.

Aussi, dans le but de préserver les mésas M₍₁₎ d'une nouvelle porosification, et plus précisément pour éviter que leurs portions inférieures 13 ne soient porosifiées, on encapsule les mésas M₍₁₎ dans la couche d'encapsulation (la même couche d'encapsulation 4 ou une couche d'encapsulation distincte). Ainsi, les mésas M₍₁₎ ne seront pas au contact de l'électrolyte liquide lors de la porosification ECE. En revanche, les mésas M₍₂₎ ne sont pas recouvertes par cette couche d'encapsulation 4, de manière à être ensuite au contact de l'électrolyte liquide.

Ensuite, on plonge à nouveau le substrat de croissance 10 dans un électrolyte liquide. L'électrode de polarisation est alors connectée au générateur électrique de manière à appliquer une tension électrique de valeur V_{ECE}. Cela se traduit par une porosification des portions inférieures 13 des mésas M₍₂₎, qui seules sont au contact de l'électrolyte liquide. Les portions inférieures 13 des mésas M₍₁₎ et M₍₀₎ ne sont donc pas porosifiées. La tension électrique appliquée entre l'anode et la cathode peut être par exemple comprise entre 1V et 100V. Elle peut être appliquée pendant une durée allant de quelques secondes à quelques heures. Une électrode de référence peut être utilisée pour contrôler précisément la tension électrique appliquée. On retire ensuite le substrat de croissance 10 du bain électrolytique, et on supprime la couche d'encapsulation 4.

On obtient ainsi un substrat de croissance 10, comportant des mésas M₍ᵢ₎ présentant différents taux de porosification P₍ᵢ₎, et formés à partir d'un même empilement cristallin 20 original. Dans la mesure où les portions de reprise d'épitaxie 15 sont présentes, il y a également relaxation des mésas, de sorte qu'elles présentent différents taux de relaxation R₍ᵢ₎. Cette relaxation des contraintes mécaniques différenciée d'une catégorie de mésas à l'autre est obtenue par la porosification électrochimique différenciée des mésas M₍ᵢ₎. Ces mésas M₍ᵢ₎ présentent toutes une portion de reprise d'épitaxie 15 en InₓGa₁₋ₓN avec la même proportion d'indium x3, mais avec une relaxation différente selon que l'on considère les différentes catégories de mésas M₍ᵢ₎. Ils sont donc adaptés à la réalisation par épitaxie d'une matrice de diodes D₍ᵢ₎ permettant d'émettre ou de recevoir un rayonnement lumineux à différentes longueurs d'onde.

En référence à la fig.3E, on fabrique ensuite la matrice de diodes D₍ᵢ₎, par reprise d'épitaxie à partir des mésas M₍ᵢ₎ du substrat de croissance 10. Dans cet exemple, les diodes sont électroluminescentes. On réalise ici des diodes D₍₀₎ à partir des mésas M₍₀₎, des diodes D₍₁₎ à partir des mésas M₍₁₎, et des diodes D₍₂₎ à partir des mésas M₍₂₎.

Pour cela, on peut retirer l'électrode de polarisation 3, puis déposer une couche isolante 6 (masque de croissance), ici de manière conforme, de manière à recouvrir la couche tampon 12 et les flancs des mésas M₍ᵢ₎. Seules les surfaces supérieures des mésas M₍ᵢ₎ sont rendues libres, de manière à former une surface de germination. La couche isolante 6 est réalisée en un matériau électriquement isolant, et peut être un oxyde ou un nitrure de silicium de 80nm d'épaisseur déposé par dépôt chimique en phase vapeur assisté par plasma (PECVD).

On réalise les diodes D₍ᵢ₎ de manière simultanée, par reprise d'épitaxie à partir de portions de reprise d'épitaxie 15 des différentes mésas M₍ᵢ₎. On forme ainsi :
- des diodes D₍₀₎, à partir des mésas M₍₀₎, adaptées à émettre à une longueur d'onde principale λ₀, par exemple une lumière bleue dont la longueur d'onde λ₀ est par exemple comprise entre 440nm et 490nm environ ;
- des diodes D₍₁₎, à partir des mésas M₍₁₎, adaptées à émettre à une longueur d'onde principale λ₁, par exemple une lumière verte dont la longueur d'onde λ₁ est par exemple comprise entre 495nm et 560nm environ ; et
- des diodes D₍₂₎, à partir des mésas M₍₂₎, adaptées à émettre à une longueur d'onde principale λ₂, par exemple une lumière rouge dont la longueur d'onde λ₂ est par exemple comprise entre 600nm et 650nm environ.

Ceci est possible par le fait que les portions de reprise d'épitaxie 15 des mésas M₍₀₎, M₍₁₎ et M₍₂₎ présentent un paramètre de maille effectif différent d'une catégorie de mésas à l'autre, du fait des taux de relaxation différents R₍₀₎, R₍₁₎ et R₍₂₎. Aussi, l'incorporation d'indium dans les diodes, et en particulier dans les puits quantiques des couches actives 32, dépend en effet du paramètre de maille effectif (et donc du taux de relaxation) des portions de reprise d'épitaxie 15 des différentes mésas. Plus le paramètre de maille effectif d'une couche de reprise d'épitaxie 15 est important, plus la longueur d'onde principale de la diode correspondante sera grande.

Les diodes D₍ᵢ₎ comportent *a minima* deux portions dopées 31, 33, l'une de type n et l'autre de type p, et une couche active intercalaire 32 comportant des puits quantiques. Les couches dopées 31, 33 et la portion active 32 peuvent être des multicouches (ainsi les puits quantiques sont classiquement situés entre des sous-couches barrières) et comporter d'autres couches ou sous-couches telles qu'une couche de blocage d'électrons.

Par ailleurs, le procédé de fabrication de la matrice de diodes comporte également une étape de réalisation d'électrodes de polarisation des diodes D₍ᵢ₎. Cette étape est classique et n'est pas décrite ici. Dans le cas où les mésas M₍ᵢ₎ sont électriquement conductrices, elles peuvent être mises à profit pour polariser les diodes. Aussi, l'électrode de polarisation 3 peut être gardée.

On obtient ainsi un dispositif optoélectronique 1 dont les diodes D₍ᵢ₎ sont adaptées ici à émettre de manière native à des longueurs d'onde différentes, ici dans les trois couleurs RGB, ceci grâce au substrat de croissance 10 dont les mésas M₍ᵢ₎ à différents niveaux de porosification P₍ᵢ₎ ont été réalisées par une porosification électrochimique différenciée, sans avoir eu recours à des étapes d'implantation spatialement localisée de dopants, et qui a permis de réaliser les diodes D₍ᵢ₎ à partir d'une seule étape de reprise d'épitaxie.

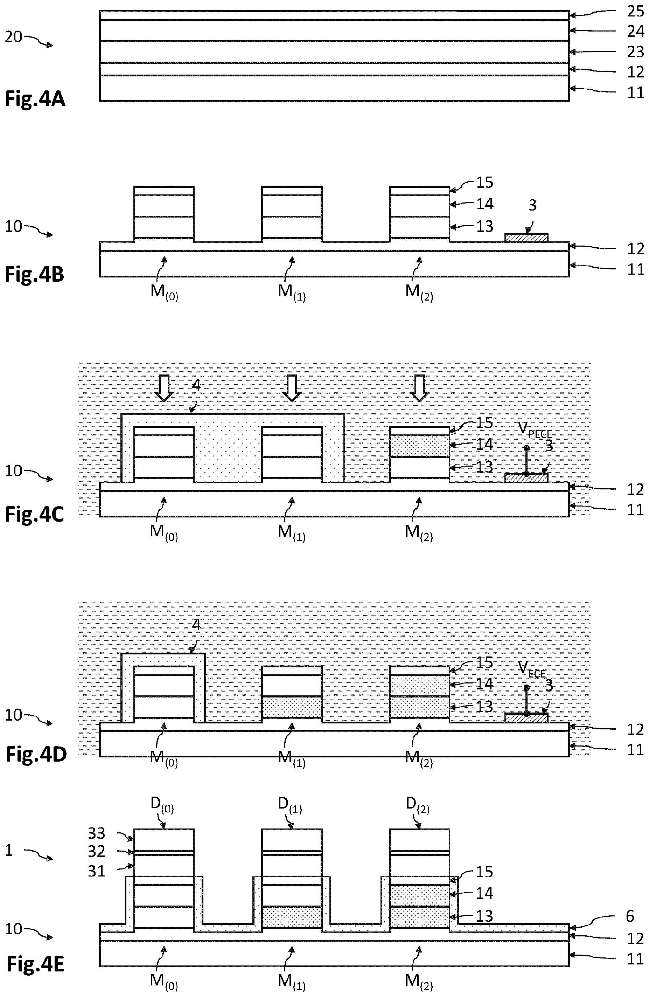

Les figures 4A à 4E illustrent différentes étapes d'un procédé de fabrication d'un substrat de croissance 10 similaire à celui de la fig.1B, puis d'une matrice de diodes D₍ᵢ₎. Le procédé de fabrication met également en œuvre une porosification PECE de portions supérieures 14 des mésas M₍ᵢ₎, suivies d'une porosification ECE de portions inférieures 13. Les étapes des fig.4A, fig.4B et fig.4E sont identiques ou similaires à celles des fig.3A, fig.3B et fig.3E : elles ne sont pas décrites à nouveau.

En référence à la fig.4C, on effectue la première étape de porosification électrochimique des mésas M₍ᵢ₎. Il s'agit ici de porosifier de manière photo-assistée la portion supérieure 14 des seules mésas M₍₂₎, et non pas celles des mésas M₍₁₎. Aussi, la couche d'encapsulation 4 recouvre les mésas M₍₀₎ ainsi que les mésas M₍₁₎. Aussi, seules les mésas M₍₂₎ ne sont pas recouvertes par la couche d'encapsulation 4 et seront au contact de l'électrolyte liquide.

Ensuite, on plonge le substrat de croissance 10 dans l'électrolyte liquide. L'électrode de polarisation 3 peut être connectée, ou non, au générateur électrique. On émet le rayonnement lumineux d'illumination en direction des mésas M₍ᵢ₎. Aussi, le rayonnement lumineux d'illumination est absorbé par la portion supérieure 14 des mésas M₍₂₎. Aussi, la portion supérieure 14 des mésas M₍₂₎ est porosifiée de manière photo-assistée. En revanche, les portions supérieures 14 des mésas M₍₀₎ et M₍₁₎ ne sont pas porosifiées car elles ne sont pas au contact de l'électrolyte liquide. La couche tampon 12 n'est pas ici porosifiée, car elle est réalisée en un matériau non porosifiable à la tension électrique V_{PECE}. Une fois les portions supérieures 14 des mésas M₍₂₎ porosifiées, on retire le substrat de croissance du bain électrolytique.

En référence à la fig.4D, on effectue la deuxième étape de porosification électrochimique des mésas M₍ᵢ₎. Il s'agit ici de porosifier de manière non photo-assistée les portions inférieures 13 des mésas M₍₁₎ et M₍₂₎, sans porosifier celles des mésas M₍₀₎. Pour cela, on supprime la partie de la couche d'encapsulation 4 qui recouvre les mésas M₍₁₎ et on garde celle qui recouvre les mésas M₍₀₎.

Ensuite, on plonge à nouveau le substrat de croissance 10 dans un électrolyte liquide. L'électrode de polarisation 3 est alors connectée au générateur électrique de manière à appliquer une tension électrique de valeur V_{ECE}. Cela se traduit par une porosification des portions inférieures 13 des mésas M₍₁₎ et M₍₂₎, qui sont au contact de l'électrolyte liquide. Les mésas M₍₀₎ ne sont pas porosifiées. On retire ensuite le substrat de croissance du bain électrolytique, ainsi que la couche d'encapsulation 4. On obtient ainsi un substrat de croissance 10 similaire à celui de la fig.1B où les mésas M₍₁₎ comportent une portion inférieure 13 porosifiée et une portion supérieure 14 non porosifiée.

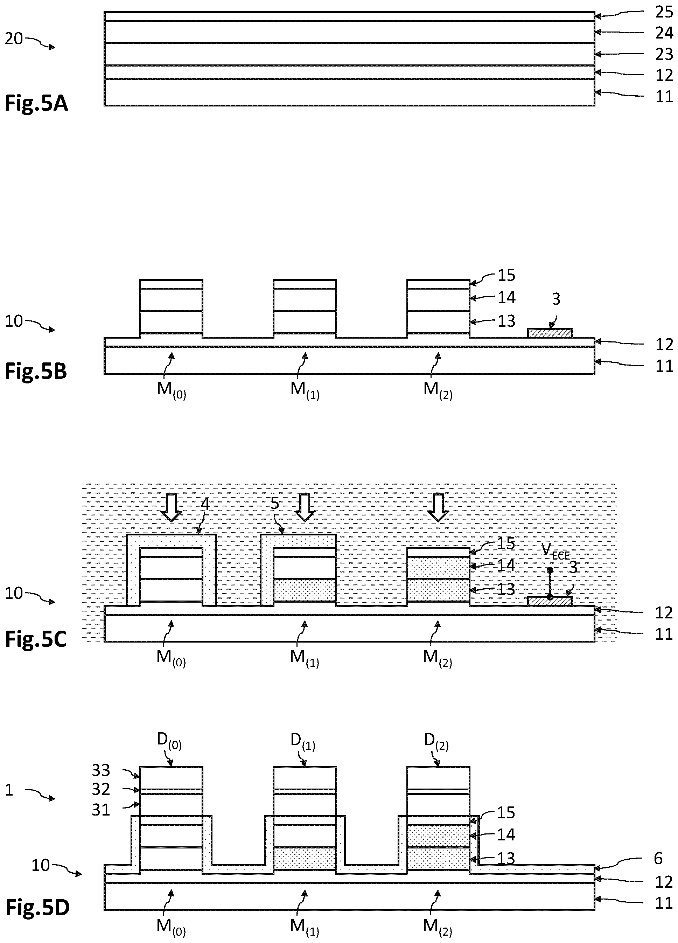

Les figures 5A à 5D illustrent différentes étapes d'un procédé de fabrication d'un substrat de croissance 10 similaire à celui de la fig.1B, puis d'une matrice de diodes D₍ᵢ₎. Le procédé de fabrication met également en œuvre une porosification PECE de portions supérieures 14 des mésas et une porosification ECE de portions inférieures 13, ces porosifications étant effectuées lors de la même étape. Les étapes des fig.5A, fig.5B et fig.5D sont identiques ou similaires à celles des fig.3A, fig.3B et fig.3E : elles ne sont pas décrites à nouveau.

En référence à la fig.5C, on effectue les porosifications PECE et ECE des mésas M₍₁₎ et M₍₂₎ lors de la même étape, c'est-à-dire lors d'une même plongée dans le bain électrolytique. Il s'agit ici de porosifier de manière photo-assistée la portion supérieure 14 des seules mésas M₍₂₎, et non pas celles des mésas M₍₁₎, et de porosifier de manière non photo-assistée les portions inférieures 13 des mésas M₍₁₎ et M₍₂₎.

Pour cela, on recouvre les mésas M₍₀₎ d'une couche d'encapsulation 4 réalisée en un matériau électriquement isolant (opaque ou non). De plus, on recouvre partiellement les mésas M₍₁₎ d'une couche opaque d'encapsulation 5 réalisée en un matériau opaque au rayonnement lumineux d'illumination. Un matériau opaque est un matériau dont le taux de transmission à la longueur d'onde λ_{c} est nul ou quasi-nul. La couche opaque d'encapsulation 5 ne recouvre partiellement les mésas M₍₁₎ dans le sens où une partie des flancs de la portion inférieure 13 est laissée libre, tout en recouvrant au moins partiellement la surface supérieure du mésa M₍₁₎, voire la totalité.

Ensuite, on plonge le substrat de croissance 10 dans un électrolyte liquide. L'électrode de polarisation 3 est alors connectée au générateur électrique de manière à appliquer une tension électrique de valeur V_{ECE}. De plus, on émet le rayonnement lumineux d'illumination en direction des mésas M₍ᵢ₎. Il est possible que V_{ECE} soit la même pour la porosification ECE et PECE, mais comme les proportions d'indium sont différentes, il est aussi possible d'utiliser une tension V_{ECE} plus faible pendant la porosification PECE et augmenter ensuite V_{ECE} pour la porosification ECE.

L'illumination des mésas M₍ᵢ₎ conduit à une porosification PECE de la portion supérieure 14 des mésas M₍₂₎ dans la mesure où seule cette portion supérieure 14 est au contact de l'électrolyte liquide et absorbe le rayonnement lumineux d'illumination. En revanche, la portion supérieure 14 des mésas M₍₁₎, bien qu'elle soit également au contact de l'électrolyte liquide, est protégée du rayonnement lumineux d'illumination par la couche opaque d'encapsulation 5 : elle n'est sensiblement pas (ou peu) porosifiée. Enfin, la portion supérieure 14 des mésas M₍₀₎ n'est pas au contact de l'électrolyte liquide : elle n'est pas porosifiée.

De plus, l'application de la tension électrique Eₚ d'une valeur V_{ECE} conduit à une porosification des portions inférieures 13 des mésas M₍₁₎ et M₍₂₎, qui seules sont au contact de l'électrolyte liquide. Les mésas M₍₀₎ ne sont pas porosifiées.

On retire ensuite le substrat de croissance du bain électrolytique, ainsi que les couches d'encapsulation 4 et 5. On obtient ainsi un substrat de croissance 10 similaire à celui de la fig.1B où les mésas M₍₁₎ et M₍₂₎ ont été porosifiées par porosification PECE et ECE. On peut ensuite réaliser les diodes (fig.5D).

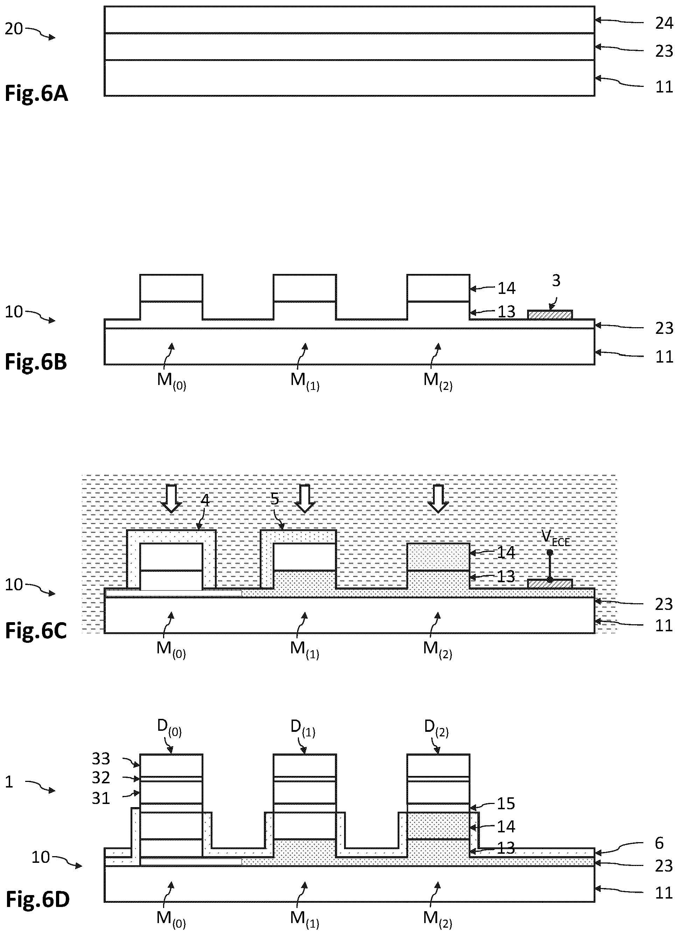

Les figures 6A à 6D illustrent différentes étapes d'un procédé de fabrication d'un substrat de croissance 10 similaire à celui de la fig.1C, puis d'une matrice de diodes D₍ᵢ₎. Le procédé de fabrication met également en œuvre des porosifications PECE et ECE effectuées lors de la même étape, bien qu'une porosification en deux étapes reste possible.

En référence à la fig.6A, on fournit tout d'abord un empilement cristallin 20. Celui-ci est identique à celui de la fig.3A, si ce n'est qu'il ne comporte pas la couche tampon 12, ni la couche continue de reprise d'épitaxie 25.

En référence à la fig.6B, on réalise les mésas M₍ᵢ₎, par gravure localisée de l'empilement cristallin 20. Les tranchées sont réalisées qui débouchent dans la couche continue inférieure 23. Elles pourraient déboucher sur la couche support 11 si elle était réalisée en un matériau (non porosifiable) électriquement conducteur. L'électrode de polarisation 3 serait alors déposée au contact de la couche support 11. En revanche, dans cet exemple, la couche support 11 est réalisée en saphir, de sorte que la couche continue inférieure 23 n'est pas gravée sur toute son épaisseur. Une partie non gravée raccorde les portions inférieures 13 les unes aux autres, et assure la connexion électrique à l'électrode de polarisation 3.

En référence à la fig.6C, on effectue les porosifications PECE et ECE des mésas M₍₁₎ et M₍₂₎ lors de la même étape. Celle-ci est identique à celle de la fig.5C et n'est donc pas décrite à nouveau en détail. Notons seulement que, au cours de la polarisation ECE, la partie de raccord de la couche continue inférieure 23 est également porosifiée en même temps que les portions inférieures 13. La partie de la couche continue inférieure 23 qui est éloignée de l'électrode de polarisation 3 peut ne pas être porosifiée dans la mesure où la résistance électrique série peut être trop élevée.

En référence à la fig.6D, on retire ensuite le substrat de croissance 10 du bain électrolytique, et on supprime les couches d'encapsulation 4, 5. Les mésas M₍ᵢ₎ présentent différents niveaux de porosification P₍ᵢ₎ mais peuvent ne pas encore présenter les taux de relaxation R₍ᵢ₎ souhaités dans la mesure où les portions de reprise d'épitaxie 15 ne sont pas encore réalisées. Après avoir déposé un masque de croissance 6 (couche isolante), on réalise ensuite les portions de reprise d'épitaxie 15, à partir des surfaces supérieures des portions supérieures 14.

On peut réaliser par épitaxie une couche mince à base de GaN, et de préférence en InGaN avec une proportion d'indium de 1% environ, d'une épaisseur comprise entre 10 et 100nm environ. Cette couche mince est réalisée sur et au contact des portions supérieures 14 des mésas M₍ᵢ₎, et permet d'obturer les pores débouchant au niveau de la face supérieure. Ensuite, on peut réaliser par épitaxie les portions de reprise d'épitaxie 15 au niveau de chaque mésa M₍ᵢ₎. Ces portions 15 peuvent présenter une épaisseur de 200nm environ et une proportion d'indium de l'ordre de 8% environ. Elles provoquent alors la déformation des portions poreuses des mésas M₍₁₎ et M₍₂₎, qui en retour permettent aux portions 15 de relaxer. Les portions dopées 31, 33 et la portion active 32 des diodes sont ensuite réalisées. Notons ici que la portion dopée 31 des diodes D₍ᵢ₎ peut alors faire office de portion de reprise d'épitaxie 15.

Des modes de réalisation particuliers viennent d'être décrits. L'invention étant limitée par les revendications ci après.

## Revendications

1. Procédé de fabrication d'un substrat de croissance (10) adapté à la réalisation par épitaxie d'une matrice de diodes à base d'InGaN, comportant les étapes suivantes :
o fournir un empilement cristallin (20) à base de GaN, comportant : une couche inférieure dopée (23) ; et une couche supérieure (24) réalisée à base d'Inₓ₂Ga₁₋ₓ₂N avec x2>0, reposant sur et au contact de la couche inférieure dopée (23) ; où :
• la couche inférieure dopée (23) présente une proportion d'indium x1≥0 prédéfinie de sorte qu'elle est non absorbante d'un rayonnement lumineux d'illumination ayant une longueur d'onde centrale prédéfinie, et la couche supérieure (24) présente une proportion d'indium x2>0 prédéfinie de sorte qu'elle est absorbante du rayonnement lumineux d'illumination ;
• la couche inférieure (23) dopée présente un niveau de dopage prédéfini de sorte qu'elle est porosifiable à une tension électrique de valeur V_{ECE} prédéfinie, et la couche supérieure (24) présente un niveau de dopage prédéfini de sorte qu'elle est non porosifiable à la tension électrique V_{ECE} prédéfinie ;
o réalisation de mésas M₍ᵢ₎, avec i allant de 0 à 2, par gravure localisée de la couche supérieure (24) pour former des portions supérieures (14) de mésas et d'au moins une partie de la couche inférieure (23) dopée pour former des portions inférieures (13) de mésas ; puis
o dépôt d'une couche d'encapsulation (4) en un matériau électriquement isolant, recouvrant au moins une mésa notée M₍₀₎, de sorte que ladite mésa M₍₀₎ n'est pas porosifiée lors d'une porosification électrochimique de mésas notées M₍₁₎ et M₍₂₎; puis
o porosification électrochimique des portions inférieure (13) et supérieure (14) d'au moins une mésa M₍₂₎ par : porosification photo-assistée de la portion supérieure (14) de la mésa M₍₂₎ par émission du rayonnement lumineux d'illumination ; et porosification non photo-assistée de la portion inférieure (13) de la mésa M₍₂₎ par application de la tension électrique de valeur V_{ECE};
o porosification électrochimique de l'une seulement des portions inférieure (13) et supérieure (14) d'au moins une mésa M₍₁₎ par : porosification photo-assistée de la portion supérieure (14) de la mésa M₍₁₎ au cours de celle de la portion supérieure de la mésa M₍₂₎ ; ou porosification non photo-assistée de la portion inférieure (13) de la mésa M₍₁₎ au cours de celle de la portion inférieure de la mésa M₍₂₎;
o retrait au moins en partie de la couche d'encapsulation (4), de manière à rendre libre une surface supérieure de la mésa M₍₀₎.

2. Procédé de fabrication selon la revendication 1, dans lequel la porosification photo-assistée et la porosification non photo-assistée sont effectuées lors d'étapes distinctes.

3. Procédé de fabrication selon la revendication 2, comportant les étapes distinctes suivantes :
o une étape de porosification photo-assistée des portions supérieures (14) des mésas M₍₁₎ et M₍₂₎, les mésas M₍₁₎ et M₍₂₎ étant au contact d'un électrolyte liquide ;
o une étape de porosification non photo-assistée de la portion inférieure (13) des mésas M₍₂₎, les mésas M₍₁₎ étant recouvertes d'une couche d'encapsulation (4) réalisée en un matériau électriquement isolant, seules les mésas M₍₂₎ étant au contact d'un électrolyte liquide.

4. Procédé de fabrication selon la revendication 2, comportant les étapes distinctes suivantes :
o une étape de porosification photo-assistée de la portion supérieure (14) des mésas M₍₂₎, les mésas M₍₁₎ étant recouvertes d'une couche d'encapsulation (4) réalisée en un matériau électriquement isolant, seules les mésas M₍₂₎ étant au contact d'un électrolyte liquide ;
o une étape de porosification non photo-assistée de la portion inférieure (13) des mésas M₍₁₎ et M₍₂₎, les mésas M₍₁₎ et M₍₂₎ étant au contact d'un électrolyte liquide.

5. Procédé de fabrication selon la revendication 1, dans lequel la porosification photo-assistée et la porosification non photo-assistée sont effectuées lors d'une même étape, une couche opaque d'encapsulation, réalisée en un matériau opaque au rayonnement lumineux d'illumination, recouvrant au moins en partie une surface supérieure des mésas M₍₁₎ tout en laissant libre une surface latérale de la portion inférieure (13) des mésas M₍₁₎.

6. Procédé de fabrication selon l'une quelconque des revendications 1 à 5, dans lequel l'empilement cristallin (20) comporte une couche continue de reprise d'épitaxie (25), reposant sur la couche supérieure (24), et réalisée à base d'InGaN ayant une proportion d'indium x3>0 prédéfinie de sorte qu'elle est non absorbante du rayonnement lumineux d'illumination, et présentant un niveau de dopage prédéfini de sorte qu'elle est non porosifiable à la tension électrique V_{ECE} prédéfinie.

7. Procédé de fabrication selon l'une quelconque des revendications 1 à 5, dans lequel l'empilement cristallin (20) ne comporte pas une couche continue de reprise d'épitaxie (25) de sorte que la couche supérieure (24) présente une face supérieure libre, des portions de reprise d'épitaxie (15) réalisée à base d'InGaN étant réalisés à partir d'une surface supérieure des portions supérieures (14) des mésas M₍₁₎ après la porosification des mésas M₍₁₎ et M₍₂₎.

8. Procédé de fabrication selon l'une quelconque des revendications 1 à 7, dans lequel, lors de la porosification photo-assistée, une tension électrique est appliquée entre le substrat de croissance (10) et une électrolyte liquide dans lequel il est plongé, d'une valeur V_{PECE} prédéfinie de sorte que les portions inférieures (13) des mésas M₍₁₎ ne sont pas porosifiées.

9. Procédé de fabrication d'un dispositif optoélectronique (1), comportant les étapes suivantes :
o fabrication du substrat de croissance (10) par le procédé selon l'une quelconque des revendications 1 à 8 ; puis
o fabrication d'une matrice de diodes D₍ᵢ₎ par épitaxie à partir des mésas M₍ᵢ₎ du substrat de croissance (10), les diodes étant alors adaptées à émettre ou à détecter un rayonnement lumineux à différentes longueurs d'onde, la longueur d'onde étant différente d'une catégorie de mésas M₍ᵢ₎ à l'autre.

10. Substrat de croissance (10), adapté à la réalisation par épitaxie d'une matrice de diodes à base d'InGaN, comportant :
∘ une couche support (11) ;
∘ des mésas M₍ᵢ₎, avec i allant de 0 à 2, réalisées à base de GaN cristallin, reposant sur la couche support (11), et comportant chacune : une portion inférieure (13) dopée présentant une proportion d'indium x1≥0 ; et une portion supérieure (14) réalisée à base d'Inₓ₂Ga₁₋ₓ₂N avec une proportion d'indium x2>x1 et présentant un niveau de dopage inférieur à celui de la portion inférieure (13), et reposant sur et au contact de la portion inférieure (13) ; les mésas étant configurées de sorte que :
• les portions inférieure (13) et supérieure (14) de la mésa M₍₀₎ sont non poreuses ;
• seule une portion parmi les portions inférieure (13) et supérieure (14) de la mésa M₍₁₎ est poreuse ;
• les portions inférieure (13) et supérieure (14) de la mésa M₍₂₎ sont poreuses.

11. Substrat de croissance (10) selon la revendication 10, dans lequel chaque mésa M₍ᵢ₎ comporte une portion de reprise d'épitaxie (15) reposant sur la portion supérieure (14), réalisée à base d'InGaN cristallin non poreux dont le paramètre de maille a^{m}_{cre} du matériau relaxé est supérieur au paramètre de maille effectif a^{e}_{cs} de la couche support (11) :
∘ la portion de reprise d'épitaxie (15) de chaque mésa M₍₂₎ présentant un paramètre de maille maximal a^{e}_{cre(2)};
o la portion de reprise d'épitaxie (15) de chaque mésa M₍₀₎ présentant un paramètre de maille a^{e}_{cre(0)} inférieur à a^{e}_{cre(2)};
o la portion de reprise d'épitaxie (15) de chaque mésa M₍₁₎ présentant un paramètre de maille intermédiaire a^{e}_{cre(1)} inférieur à a^{e}_{cre(2)} et différent de a^{e}_{cre(0)}.

12. Substrat de croissance (10) selon la revendication 10 ou 11, dans lequel les portions inférieures (13) des mésas M₍ᵢ₎ repose sur une couche continue (12 ; 23) réalisée en un matériau électriquement conducteur.

13. Dispositif optoélectronique (1) comportant : un substrat de croissance (10) selon l'une quelconque des revendications 10 à 12 ; et une matrice de diodes D₍ᵢ₎ à base d'InGaN, épitaxiées à partir des mésas du substrat de croissance (10), les diodes étant adaptées à émettre ou à détecter un rayonnement lumineux à différentes longueurs d'onde, la longueur d'onde étant différente d'une catégorie de mésas M₍ᵢ₎ à l'autre.

## Patentansprüche

1. Verfahren zum Fertigen eines Wachstumssubstrats (10), das für das epitaktische Herstellen einer Matrix aus Dioden auf Basis von InGaN ausgelegt ist, umfassend die folgenden Schritte:
o Bereitstellen eines kristallinen Stapels (20) auf Basis von GaN, umfassend: eine dotierte untere Schicht (23); und eine obere Schicht (24), die auf Basis von Inₓ₂Ga₁₋ₓ₂N hergestellt ist, wobei x2>0, die auf der dotierten unteren Schicht (23) aufliegt und mit dieser in Kontakt steht; wobei:
• die dotierte untere Schicht (23) einen vordefinierten Anteil an Indium x1≥0 aufweist, so dass sie für eine Beleuchtungslichtstrahlung mit einer vordefinierten zentralen Wellenlänge nicht absorbierend ist, und die obere Schicht (24) einen vordefinierten Anteil an Indium x2>0 aufweist, so dass sie für die Beleuchtungslichtstrahlung absorbierend ist;
• die dotierte untere Schicht (23) einen vordefinierten Dotierungspegel aufweist, so dass sie bei einer elektrischen Spannung mit einem vordefinierten Wert V_{ECE} porosierbar ist, und die obere Schicht (24) einen vordefinierten Dotierungspegel aufweist, so dass sie bei der vordefinierten elektrischen Spannung V_{ECE} nicht porosierbar ist;
∘ Herstellen von Mesas M₍ᵢ₎, wobei i im Bereich von 0 bis 2 liegt, durch lokales Ätzen der oberen Schicht (24), um obere Abschnitte (14) von Mesas zu bilden, und von mindestens einem Teil der dotierten unteren Schicht (23), um untere Abschnitte (13) von Mesas zu bilden; dann
∘ Aufbringen einer Verkapselungsschicht (4) aus einem elektrisch isolierenden Material, die mindestens eine mit M₍₀₎ bezeichnete Mesa bedeckt, so dass die Mesa M₍₀₎ während eines elektrochemischen Porosifizierens der mit M₍₁₎ und M₍₂₎ bezeichneten Mesas nicht porosiert wird; dann
o elektrochemisches Porosifizieren des unteren (13) und des oberen (14) Abschnitts von mindestens einer Mesa M₍₂₎ durch: fotogestütztes Porosifizieren des oberen Abschnitts (14) der Mesa M₍₂₎ durch Emission der Beleuchtungslichtstrahlung; und nicht fotogestütztes Porosifizieren des unteren Abschnitts (13) der Mesa M₍₂₎ durch Anlegen der elektrischen Spannung mit dem Wert V_{ECE};
o elektrochemisches Porosifizieren von nur einem von dem unteren (13) und dem oberen (14) Abschnitt von mindestens einer Mesa M₍₁₎ durch: fotogestütztes Porosifizieren des oberen Abschnitts (14) der Mesa M₍₁₎ während des des oberen Abschnitts der Mesa M₍₂₎; oder nicht fotogestütztes Porosifizieren des unteren Abschnitts (13) der Mesa M₍₁₎ während des des unteren Abschnitts der Mesa M₍₂₎;
o mindestens teilweises Entfernen der Verkapselungsschicht (4), um eine obere Oberfläche der Mesa M₍₀₎ frei zu legen.

2. Fertigungsverfahren nach Anspruch 1, wobei das fotogestützte Porosifizieren und das nicht fotogestützte Porosifizieren in verschiedenen Schritten durchgeführt werden.

3. Fertigungsverfahren nach Anspruch 2, umfassend die folgenden verschiedenen Schritte:
o einen Schritt des fotogestützten Porosifizierens der oberen Abschnitte (14) der Mesas M₍₁₎ und M₍₂₎, wobei die Mesas M₍₁₎ und M₍₂₎ in Kontakt mit einem flüssigen Elektrolyten stehen;
o einen Schritt des nicht fotogestützten Porosifizierens des unteren Abschnitts (13) der Mesas M₍₂₎, wobei die Mesas M₍₁₎ mit einer Verkapselungsschicht (4) bedeckt sind, die aus einem elektrisch isolierenden Material hergestellt ist, wobei nur die Mesas M₍₂₎ in Kontakt mit einem flüssigen Elektrolyten stehen.

4. Fertigungsverfahren nach Anspruch 2, umfassend die folgenden verschiedenen Schritte:
o einen Schritt des fotogestützten Porosifizierens des oberen Abschnitts (14) der Mesas M₍₂₎, wobei die Mesas M₍₁₎ mit einer Verkapselungsschicht (4) bedeckt sind, die aus einem elektrisch isolierenden Material hergestellt ist, wobei nur die Mesas M₍₂₎ in Kontakt mit einem flüssigen Elektrolyten stehen;
o einen Schritt des nicht fotogestützten Porosifizierens des unteren Abschnitts (13) der Mesas M₍₁₎ und M₍₂₎, wobei die Mesas M₍₁₎ und M₍₂₎ in Kontakt mit einem flüssigen Elektrolyten stehen.

5. Fertigungsverfahren nach Anspruch 1, wobei das fotogestützte Porosifizieren und das nicht fotogestützte Porosifizieren im selben Schritt durchgeführt werden, wobei eine lichtundurchlässige Verkapselungsschicht, die aus einem für die Beleuchtungslichtstrahlung lichtundurchlässigen Material hergestellt ist, mindestens teilweise eine obere Oberfläche der Mesas M₍₁₎ bedeckt, während eine seitliche Oberfläche des unteren Abschnitts (13) der Mesas M₍₁₎ dabei frei bleibt.

6. Fertigungsverfahren nach einem der Ansprüche 1 bis 5, wobei der kristalline Stapel (20) eine durchgehende Epitaxiewiederholungsschicht (25) umfasst, die auf der oberen Schicht (24) aufliegt und auf Basis von InGaN mit einem vordefinierten Anteil an Indium x3>0 hergestellt ist, so dass sie für die Beleuchtungslichtstrahlung nicht absorbierend ist, und einen vordefinierten Dotierungspegel aufweist, so dass sie bei der vordefinierten elektrischen Spannung V_{ECE} nicht porosierbar ist.

7. Fertigungsverfahren nach einem der Ansprüche 1 bis 5, wobei der kristalline Stapel (20) keine durchgehende Epitaxiewiederholungsschicht (25) umfasst, so dass die obere Schicht (24) eine freie Oberseite aufweist, wobei auf Basis von InGaN hergestellte Epitaxiewiederholungsabschnitte (15) von einer oberen Oberfläche der oberen Abschnitte (14) der Mesas M₍₁₎ nach dem Porosifizieren der Mesas M₍₁₎ und M₍₂₎ hergestellt werden.

8. Fertigungsverfahren nach einem der Ansprüche 1 bis 7, wobei während des fotogestützten Porosifizierens eine elektrische Spannung zwischen dem Wachstumssubstrat (10) und einem flüssigen Elektrolyten, in den es eingetaucht ist, mit einem vordefinierten Wert V_{PECE} angelegt wird, so dass die unteren Abschnitte (13) der Mesas M₍₁₎ nicht porosiert werden.

9. Verfahren zum Fertigen einer optoelektronischen Vorrichtung (1), umfassend die folgenden Schritte:
o Fertigen des Wachstumssubstrats (10) durch das Verfahren nach einem der Ansprüche 1 bis 8; dann
o epitaktisches Fertigen einer Matrix aus Dioden D₍ᵢ₎ aus den Mesas M₍ᵢ₎ des Wachstumssubstrats (10), wobei die Dioden dann dazu ausgelegt sind, um eine Lichtstrahlung mit verschiedenen Wellenlängen zu emittieren oder zu detektieren, wobei die Wellenlänge von einer Kategorie von Mesas M₍ᵢ₎ zur anderen verschieden ist.

10. Wachstumssubstrat (10), das für das epitaktische Herstellen einer Matrix aus Dioden auf Basis von InGaN ausgelegt ist, umfassend:
o eine Trägerschicht (11);
o Mesas M₍ᵢ₎, wobei i im Bereich von 0 bis 2 liegt, die auf Basis von kristallinem GaN hergestellt sind, auf der Trägerschicht (11) aufliegen und jeweils Folgendes umfassen: einen dotierten unteren Abschnitt (13), der einen Anteil an Indium x1≥0 aufweist; und einen oberen Abschnitt (14), der auf Basis von Inₓ₂Ga₁₋ₓ₂N mit einem Anteil an Indium x2>x1 hergestellt ist und einen geringeren Dotierungspegel als der des unteren Abschnitts (13) aufweist und auf dem unteren Abschnitt (13) aufliegt und mit diesem in Kontakt steht; wobei die Mesas so konfiguriert sind, dass:
• der untere (13) und der obere (14) Abschnitt der Mesa M₍₀₎ nicht porös sind;
• nur ein Abschnitt von dem unteren (13) und dem oberen (14) Abschnitt der Mesa M₍₁₎ porös ist;
• der untere (13) und der obere (14) Abschnitt der Mesa M₍₂₎ porös sind.

11. Wachstumssubstrat (10) nach Anspruch 10, wobei jede Mesa M₍ᵢ₎ einen Epitaxiewiederholungsabschnitt (15) umfasst, der auf dem oberen Abschnitt (14) aufliegt und auf Basis von nicht porösem kristallinem InGaN hergestellt ist, dessen Maschenparameter a^{m}_{cre} des entspannten Materials größer ist als der effektive Maschenparameter a^{e}_{cs} der Trägerschicht (11):
o wobei der Epitaxiewiederholungsabschnitt (15) jeder Mesa M₍₂₎ einen maximalen Maschenparameter a^{e}_{cre(2)} aufweist;
o wobei der Epitaxiewiederholungsabschnitt (15) jeder Mesa M₍₀₎ einen Maschenparameter a^{e}_{cre(0)} aufweist, der kleiner als a^{e}_{cre(2)} ist;
o wobei der Epitaxiewiederholungsabschnitt (15) jeder Mesa M₍₁₎ einen Zwischenmaschenparameter a^{e}_{cre(1)} aufweist, der kleiner als a^{e}_{cre(2)} ist und sich von a^{e}_{cre(0)} unterscheidet.

12. Wachstumssubstrat (10) nach Anspruch 10 oder 11, wobei die unteren Abschnitte (13) der Mesas M₍ᵢ₎ auf einer durchgehenden Schicht (12; 23) aufliegen, die aus einem elektrisch leitenden Material hergestellt ist.

13. Optoelektronische Vorrichtung (1), umfassend: ein Wachstumssubstrat (10) nach einem der Ansprüche 10 bis 12; und eine Matrix aus Dioden D₍ᵢ₎ auf Basis von InGaN, die aus den Mesas des Wachstumssubstrats (10) epitaktisch hergestellt sind, wobei die Dioden dazu ausgelegt sind, eine Lichtstrahlung mit verschiedenen Wellenlängen zu emittieren oder zu detektieren, wobei die Wellenlänge von einer Kategorie von Mesas M₍ᵢ₎ zur anderen verschieden ist.

## Claims

1. A method for manufacturing a growth substrate (10) adapted for producing by epitaxy a matrix of diodes based on InGaN, comprising the following steps:
- providing a crystalline stack (20) based on GaN, comprising: a doped lower layer (23); and an upper layer (24) made from Inₓ₂Ga₁₋ₓ₂N with x2>0, resting on and in contact with the doped lower layer (23); where:
- the doped lower layer (23) has a predefined proportion of indium x1≥0 such that it is non-absorbent to an illuminating light radiation having a predefined central wavelength, and the upper layer (24) has a predefined proportion of indium x2>0 such that it is absorbent of illuminating light radiation;
- the doped lower layer (23) has a predefined doping level such that it is porosifiable at an electrical voltage of predefined value V_{ECE}, and the upper layer (24) has a predefined doping level such that it is non-porosifiable at the predefined electrical voltage V_{ECE};
- producing mesas M₍ᵢ₎, with i ranging from 0 to 2, by localised etching of the upper layer (24) to form upper portions (14) of mesas and of at least a part of the lower layer (23) doped to form lower portions (13) of mesas; then
- depositing an encapsulation layer (4) made of an electrically insulating material, covering at least one mesa denoted M₍₀₎, such that said mesa M₍₀₎ is not porosified during an electrochemical porosification of mesas denoted M₍₁₎ and M₍₂₎; then
- electrochemically porosifying the lower (13) and upper (14) portions of at least one mesa M₍₂₎ by: photo-assisted porosification of the upper portion (14) of the mesa M₍₂₎ by emission of the illuminating light radiation; and non-photo-assisted porosification of the lower portion (13) of the mesa M₍₂₎ by application of the electrical voltage of value V_{ECE};
- electrochemically porosifying only one of the lower (13) and upper (14) portions of at least one mesa M₍₁₎ by: photo-assisted porosification of the upper portion (14) of the mesa M₍₁₎ during that of the upper portion of the mesa M₍₂₎; or non-photo-assisted porosification of the lower portion (13) of the mesa M₍₁₎ during that of the lower portion of the mesa M₍₂₎;
- removing, at least in part, the encapsulation layer (4), so as to expose an upper surface of the mesa M₍₀₎.

2. The manufacturing method according to claim 1, wherein the photo-assisted porosification and the non-photo-assisted porosification are carried out in separate steps.

3. The manufacturing method according to claim 2, comprising the following distinct steps:
- a step of photo-assisted porosification of the upper portions (14) of the mesas M₍₁₎ and M₍₂₎, the mesas M₍₁₎ and M₍₂₎ being in contact with a liquid electrolyte;
- a step of non-photo-assisted porosification of the lower portion (13) of the mesas M₍₂₎, the mesas M₍₁₎ being covered with an encapsulation layer (4) made of an electrically insulating material, only the mesas M₍₂₎ being in contact with a liquid electrolyte.

4. The manufacturing method according to claim 2, comprising the following distinct steps:
- a step of photo-assisted porosification of the upper portion (14) of the mesas M₍₂₎, the mesas M₍₁₎ being covered with an encapsulation layer (4) made of an electrically insulating material, only the mesas M₍₂₎ being in contact with a liquid electrolyte;
- a step of non-photo-assisted porosification of the lower portion (13) of the mesas M₍₁₎ and M₍₂₎, the mesas M₍₁₎ and M₍₂₎ being in contact with a liquid electrolyte.

5. The manufacturing method according to claim 1, wherein the photo-assisted porosification and the non-photo-assisted porosification are carried out during the same step, an opaque encapsulation layer, made of a material opaque to the illuminating light radiation, at least partially covering an upper surface of the mesas M₍₁₎ while leaving a lateral surface of the lower portion (13) of the mesas M₍₁₎ free.

6. The manufacturing method according to any one of claims 1 to 5, wherein the crystalline stack (20) comprises a continuous epitaxial regrowth layer (25), resting on the upper layer (24), and made from InGaN having a predefined proportion of indium x3>0 such that it is non-absorbent of the illuminating light radiation, and having a predefined doping level such that it is non-porosifiable at the predefined electrical voltage V_{ECE}.

7. The manufacturing method according to any one of claims 1 to 5, wherein the crystalline stack (20) does not comprise a continuous epitaxial regrowth layer (25) so that the upper layer (24) has a free upper face, epitaxial regrowth portions (15) produced using InGaN being produced from an upper surface of the upper portions (14) of the mesas M₍₁₎ after the porosification of the mesas M₍₁₎ and M₍₂₎.

8. The manufacturing method according to any one of claims 1 to 7, wherein, during the photo-assisted porosification, an electric voltage is applied between the growth substrate (10) and a liquid electrolyte wherein it is immersed, of a predefined value V_{PECE} so that the lower portions (13) of the mesas M₍₁₎ are not porosified.

9. A method for manufacturing an optoelectronic device (1), comprising the following steps:
- manufacturing the growth substrate (10) by the method according to any one of claims 1 to 8; then
- manufacturing a matrix of diodes D₍ᵢ₎ by epitaxy from the mesas M₍ᵢ₎ of the growth substrate (10), the diodes then being adapted to emit or detect light radiation at different wavelengths, the wavelength being different from one category of mesas M₍ᵢ₎ to another.

10. A growth substrate (10), adapted for the production by epitaxy of a diode matrix based on InGaN, comprising:
- a support layer (11);
- mesas M₍ᵢ₎, with i ranging from 0 to 2, made from crystalline GaN, resting on the support layer (11), and each comprising: a doped lower portion (13) having an indium proportion x1≥0; and an upper portion (14) made from Inₓ₂Ga₁₋ₓ₂N with an indium proportion x2>x1 and having a doping level lower than that of the lower portion (13), and resting on and in contact with the lower portion (13); the mesas being configured so that:
- the lower (13) and upper (14) portions of the mesa M₍₀₎ are non-porous;
- only one portion among the lower (13) and upper (14) portions of the mesa M₍₁₎ is porous;
- the lower (13) and upper (14) portions of the mesa M₍₂₎ are porous.

11. The growth substrate (10) according to claim 10, wherein each mesa M₍ᵢ₎ comprises an epitaxial regrowth portion (15) resting on the upper portion (14), made from non-porous crystalline InGaN whose lattice parameter a^{m}_{cre} of the relaxed material is greater than the effective lattice parameter a^{e}_{cs} of the support layer (11):
- the epitaxial regrowth portion (15) of each mesa M₍₂₎ having a maximum lattice parameter a^{e}_{cre(2)};
- the epitaxial regrowth portion (15) of each mesa M₍₀₎ having a lattice parameter a^{e}_{cre(0)} less **than** a^{e}_{cre(2)};
- the epitaxial regrowth portion (15) of each mesa M₍₁₎ having an intermediate lattice parameter a^{e}_{cre(i)} less **than** a^{e}_{cre(2)} and different from a^{e}_{cre(0)}.

12. The growth substrate (10) according to claim 10 or 11, wherein the lower portions (13) of the mesas M₍ᵢ₎ rest on a continuous layer (12; 23) made of an electrically conductive material.

13. An optoelectronic device (1) comprising: a growth substrate (10) according to any one of claims 10 to 12; and a matrix of diodes D₍ᵢ₎ based on InGaN, epitaxially grown from the mesas of the growth substrate (10), the diodes being adapted to emit or detect light radiation at different wavelengths, the wavelength being different from one category of mesas M₍ᵢ₎ to another.
